(19) **Europäisches Patentamt / European Patent Office / Office européen des brevets**

(11) **EP 3 336 424 B1**

(12) **EUROPEAN PATENT SPECIFICATION**

(45) Date of publication and mention
of the grant of the patent:
**13.05.2020   Bulletin 2020/20**

(21) Application number: **17839011.8**

(22) Date of filing: **19.05.2017**

(51) Int Cl.:
*F21V 33/00* (2006.01)         *F21S 8/00* (2006.01)
*H01L 51/50* (2006.01)       *F21Y 115/15* (2016.01)
*F21Y 105/10* (2016.01)

(86) International application number:
**PCT/JP2017/018827**

(87) International publication number:
**WO 2018/029936 (15.02.2018 Gazette 2018/07)**

(54) **BUILDING MATERIAL WITH INTEGRATED LIGHT-EMITTING DEVICE**

BAUSTOFF MIT INTEGRIERTER LICHTEMITTIERENDER VORRICHTUNG

MATÉRIAU DE CONSTRUCTION DOTÉ D'UN DISPOSITIF ÉLECTROLUMINESCENT INTÉGRÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **08.08.2016   JP 2016156004**

(43) Date of publication of application:
**20.06.2018   Bulletin 2018/25**

(73) Proprietor: **Kaneka Corporation
Osaka-shi, Osaka 530-8288 (JP)**

(72) Inventors:
• **YAMAGUCHI Youichi
Tokyo 107-6025 (JP)**

• **OKUYAMA Yuzuru
Tokyo 107-6025 (JP)**

(74) Representative: **Hoffmann Eitle
Patent- und Rechtsanwälte PartmbB
Arabellastraße 30
81925 München (DE)**

(56) References cited:
**WO-A1-2009/008249     WO-A1-2013/027508
WO-A1-2015/071454     WO-A1-2015/083483
WO-A1-2015/122319     GB-A- 975 125
JP-A- 2015 011 778     JP-A- 2016 021 347
US-A1- 2015 309 247**

**Description**

TECHNICAL FIELD

The present invention relates to a light-emitting-device-integrated building material in which appearance of a portion forming an external surface thereof is changed by light emission from inside by a light emitting device.

BACKGROUND ART

Conventionally, as a building material for forming a wall surface of a building such as a window material and a wall material, a building material using a light emitting device has been known. For example, Patent Document 1 discloses a structure in which a building material is formed by attaching a plate-shaped organic EL element to the inside of a frame-shaped holding section.

The structure disclosed in Patent Document 1 is configured to solve a problem that a frame section (non-light emitting region) is darker than the light emitting section and thus is outstanding when a plurality of organic EL elements are tiled (two-dimensionally arranged such that tiles are arranged side by side). Specifically, an insulating layer to be formed continuously to a first electrode is formed in a shape with a protrusion protruding in its thickness direction. When an organic light emitting layer or a second electrode are formed later, forming such an insulating layer causes film forming materials thereof to be less likely to spread to an edge side of an organic EL element, so that length of the insulating layer in its width direction can be shortened. As a result, the frame section of the organic EL element can be narrowed, so that a portion to be darkened is narrowed to enable the frame section to be relatively less outstanding.

PRIOR ART DOCUMENT

PATENT DOCUMENT

Patent Document 1: JP 2016-21347 A

DISCLOSURE OF INVENTION

TECHNICAL PROBLEM

The present inventors have considered a building material in which translucent decorative boards having translucency are stacked on the outside of a light emitting surface of a surface emitting panel, as a building material with higher design flexibility. In other words, the building material can change appearance impression by turning off and on the surface emitting panel. This building material allows a pattern on a surface of a decorative board to be seen as usual when the surface emitting panel is turned off, and allows the pattern of the decorative board to be arranged in the whole glowing dimly when the surface emitting panel is turned on. This enables impression different from usual to be given at the time of lighting.

However, when a plurality of surface emitting panels are disposed side by side inside a large decorative board so as to form a wall surface spreading over a wide area, dimly glowing of the entire decorative board causes a problem that a significantly outstanding darker portion than its periphery is formed in a part of the outer surface of the decorative board. In other words, formation of a darkened portion near a boundary between adjacent surface emitting panels causes a problem that a portion darker than its periphery is formed in a part of the outer surface of the decorative board at a position where the darkened portion is overlapped.

This problem also occurs when the organic EL panel disclosed in Patent Document 1, or an organic EL panel having a relatively small non-light emitting region, is used, for example. That is, the non-light emitting region of the organic EL panel is relatively narrow, but is not completely eliminated, so that a dark portion is formed near a boundary between adjacent surface emitting panels.

In addition, when an organic EL panel having a specific shape is used for an insulating section, a manufacturing process of the organic EL panel is more complicated than the ordinary organic EL panel, so that there is also a problem in that the organic EL panel becomes relatively expensive. That is, the organic EL panel becomes relatively expensive, and as a result, manufacturing costs of the light-emitting-device-integrated building material increase.

It is therefore an objective of the present invention to provide a light-emitting-device-integrated building material having a simple structure that can be manufactured at a relatively low cost, and having high design flexibility in which a significantly outstanding dark portion is not formed on a surface thereof.

WO 2015/071454 A1 discloses an OLED lighting means lying flat on an at least partially light transmissive carrier place and formed as an OLED panel.

SOLUTION TO PROBLEM

As a result of intensive investigation by the present inventors to solve the above problems, the present inventors have found that light from a surface emitting panel emitting light toward an inner surface of a decorative member is scattered to reach a non-light emitting region (or outside the non-light emitting region) positioned in a peripheral end side of the surface emitting panel. That is, the present inventors have found that while a portion of an external surface of the decorative member positioned outside the non-light emitting region becomes darker than a portion positioned outside a light emitting region in a normal case, scattered light prevents a significantly outstanding dark portion from being formed.

As a result of temporarily preparing various light-emitting-device-integrated building materials and repeating experiments, it has been found that forming the following light-emitting-device-integrated building material allows no significantly outstanding dark portion to be formed on the external surface of the decorative member.

That is, an aspect of the present invention to solve the above problem provides a light-emitting-device-integrated building material that constitutes at least part of an external surface of a structure, comprising: a decorative member, part of its outer surface constituting the external surface; and two or more of surface emitting panels disposed in parallel such that each of their light emitting surfaces faces outward, the two or more of surface emitting panels constituting an inner light emitting section, wherein the two or more of surface emitting panels includes a first surface emitting panel and a second surface emitting panel, the first surface emitting panel and the second surface emitting panel being disposed adjacent to each other in a parallel direction, the first surface emitting panel and the second surface emitting panel being disposed in contact with each other or at an interval, wherein an inter-panel non-light emitting region is constituted between a light emitting surface of the first surface emitting panel and a light emitting surface of the second surface emitting panel, the inter-panel non-light emitting region including at least a boundary portion between the first surface emitting panel and the second surface emitting panel, or at least the interval, wherein the decorative member is disposed outside the inner light emitting section and across the light emitting surface of the first surface emitting panel, the inter-panel non-light emitting region, and the light emitting surface of the second surface emitting panel, an outer surface of the decorative member including a projection plane overlapping region disposed outside the inter-panel non-light emitting region, and wherein the decorative member and the inner light emitting section satisfy a following condition (1):

(1) when an average value of luminance per unit area of the inter-panel non-light emitting region in a front view is indicated as A1, and an average value of luminance per unit area of the projection plane overlapping region is indicated as A2, a value of X1 in the following expression (A) is 55 or more and 3000 or less,

$$\text{following expression (A) is 55 or more and 3000 or less, } X1 = (A2/A1) * 100 - 100 \dots (A).$$

According to the light-emitting-device-integrated building material of the present invention, a portion that is darker than its periphery and linearly extends continuously is not visually recognized in the projection plane overlapping region, so that it is possible to provide a light-emitting-device-integrated building material having a simple structure and high design flexibility, in which no significantly dark portion is formed on its surface.

In the present aspect, a plurality of second portions each having a refractive index different from that of an adjacent portion are provided inside the decorative member, and at least one of the second portions has a planar portion extending in a direction that is different from a direction orthogonal to the outer surface of the decorative member, and that intersects with the outer surface of the decorative member.

According to this preferable aspect, light emitted from the surface emitting panel can be scattered more efficiently, and the periphery of the inter-panel non-light emitting region can be brighter. Thus, it is possible to prevent a significantly outstanding dark portion from being formed on a surface of the surface emitting panel without improving luminance of the surface emitting panel itself.

In this aspect, the two light emitting surfaces of the first surface emitting panel and the second surface emitting panel are defined each as a reference light emitting surface, the two light emitting surfaces being adjacent to the inter-panel non-light emitting region, and the decorative member and the inner light emitting section satisfy a relation of the following condition (2):

(2) when an average value of luminance per unit area of the reference light emitting surface is indicated as A3, a value of X2 in the following expression (B) is 1.5 or more and 100 or less,

$$\text{or less, } X2 = ((A2 - A1)/A3) * 100 \dots (B).$$

It is more preferable that the present aspect is configured as follows: the surface emitting panel includes a panel body and a frame member, at least part of the frame member is disposed adjacent to the boundary portion or the interval, and at least part of an outer surface of the frame member is a reflecting surface that reflects light, the part of the outer surface being disposed adjacent to the boundary portion or the interval.

According to this preferable aspect, light emitted from the surface emitting panel can be scattered more efficiently near the inter-panel non-light emitting region. Thus, it is very preferable for making the periphery of the inter-panel non-light emitting region brighter.

In the present aspect, it is more preferable that a distance between the light emitting surface of the surface emitting panel and an inner surface of the decorative member is 2 mm or more and 10 mm or less.

According to this preferable aspect, light emitted from the surface emitting panel can be scattered more efficiently.

In the present aspect, it is more preferable that the decorative member has a thickness direction orthogonal to the outer surface of the decorative member, a thickness of the decorative member being 3 mm or more and 50 mm or less.

According to this preferable aspect, it is possible to ensure a sufficient strength as a building material, and to suppress deterioration in design flexibility and in degree of freedom in design, due to excessive increase in thickness of the decorative member.

It is more preferable that the decorative member is disposed with its inner surface in contact with the light emitting surfaces of the first and the second surface emitting panels or with its inner surface away outward from the light emitting surfaces; and there is not another member between the inner surface of the decorative member and the light emitting surface of the first surface emitting panel, between the inner surface of the decorative member and the inter-panel non-light emitting region, and between the inner surface of the decorative member and the light emitting surface of the second surface emitting panel.

According to this preferable aspect, it is possible to simplify structure and more efficiently scatter light.

It is more preferable that the inner light emitting section comprises three or more of the surface emitting panels in parallel, the decorative member being disposed outside a portion across the three or more of the surface emitting panels so as to overlap with at least a part of each of the surface emitting panels in an inside-outside direction, the surface emitting panels provided in the inner light emitting section are electrically connected to each other in series, and each of the surface emitting panels has substantially identical average value of luminance per unit area on its light emitting surface.

The term, "substantially identical" means that an error of a few percent is permitted.

According to this preferable aspect, it is possible to provide a building material that can form a wide range of an external surface of a structure, and that has less luminance unevenness and high design flexibility.

In the present aspect, it is more preferable that the surface emitting panel is an organic EL panel that emits scattered light.

It is more preferable that the plurality of second portions are each a translucent granular section, the decorative member includes a translucent colored layer having a plurality of the granular sections scattered inside the colored layer, the colored layer and the granular sections with different refractive indices being disposed adjacent to each other inside the decorative member, and the plurality of the granular sections includes a first of the granular section and a second of the granular section each having at least a different outline or a grain size.

It is more preferable that the second portions are a second translucent colored layer, and the decorative member includes a first translucent colored layer having the second colored layer therein, the first and the second colored layers with a different refractive index being disposed adjacent to each other.

According to these preferable aspects, light can be more efficiently scattered.

It is more preferable that the light-emitting-device-integrated building material comprises a panel mounting member fixing a plurality of the surface emitting panels to constitute the inner light emitting section, the panel mounting member comprises recessed sections that allows the plurality of the surface emitting panels therein, and each of the plurality of the surface emitting panels is fitted into the different recessed section to be disposed in parallel.

According to this preferable aspect, mounting and positioning of the surface emitting panel is easy and this aspect is preferable.

EFFECT OF INVENTION

According to the present invention, it is possible to provide a light-emitting-device-integrated building material with a simple structure and high design flexibility that does not form a significantly outstanding dark portion on its surface.

BRIEF DESCRIPTION OF DRAWINGS

Fig. 1 is an explanatory view schematically illustrating an example in which a light-emitting-device-integrated building material according to an embodiment of the present invention is used as a building material for interior.

Figs. 2A and 2B are explanatory views illustrating a light-emitting-device-integrated building material in Fig. 1, wherein Fig. 2A illustrates a state in which each light emitting section in an inner light emitting section does not emit light, and Fig. 2B shows a state in which each light emitting section emits light in the inner light emitting section.

Fig. 3 is an exploded perspective view illustrating the light-emitting-device-integrated building material in Fig. 2.

Figs. 4A and 4B are views illustrating a decorative member in Fig. 3, wherein Fig. 4A is a perspective view when viewed from a different direction, and Fig. 4B is a sectional view illustrating a part of a section taken along a horizontal plane orthogonal to an outer surface.

Fig. 5 is an exploded perspective view illustrating a planar light emitting device in Fig. 3.

Fig. 6 is an explanatory view illustrating a state where the light-emitting-device-integrated building material in Fig. 2 is about to be fixed to a wall surface.

Fig. 7 is a front view illustrating an internal light emitting section in Fig. 6.

Fig. 8 is a plan view schematically illustrating a building material in Fig. 2.

Figs. 9A and 9B are explanatory views illustrating each region to be measured when luminance is measured in the building material in Fig. 2, while surrounding each region by thick lines and dotted lines, wherein Fig. 9A illustrates the internal light emitting section in which a decorative member is removed from a part of the front thereof, and Fig. 9B illustrates a state in which the internal light emitting section is covered with the decorative member.

Figs. 10A and 10B are views illustrating a light-emitting-device-integrated building material different from that in Fig. 1, wherein Fig. 10A is a perspective view of only a decorative member when viewed from the inside, and Fig. 10B is a plan view schematically illustrating a state when viewed from above.

Figs. 11A and 11B are views illustrating a light-emitting-device-integrated building material different from that in each figure described above, wherein Fig. 11A is a perspective view of only a decorative member when viewed from the inside, and Fig. 11B is a partially broken perspective view schematically illustrating a state of being fixed to a wall surface while enlarging a main portion.

Fig. 12 is an explanatory view illustrating a planar light emitting device different from that in Fig. 5 and a mounting fixture for fixing such a planar light emitting device to a wall surface.

Fig. 13 is an explanatory view illustrating a state of fixing a light-emitting-device-integrated building material different from that in each figure described above to a wall surface while illustrating a state of forming an inner light emitting section and fixing it to the wall surface.

Fig. 14 is an explanatory view illustrating a state of fixing a decorative member to the outside of an inner light emitting section, following Fig. 13.

Fig. 15 is a front view illustrating the inner light emitting section of Fig. 14.

Fig. 16 is an explanatory view illustrating a state of fixing a light-emitting-device-integrated building material different from that in each figure above to a wall surface.

Fig. 17 is an explanatory view illustrating a state of fixing a light-emitting-device-integrated building material different from that in each figure described above to a wall surface.

Figs. 18A and 18B are views illustrating a decorative member different from that in Fig. 4, wherein Fig. 18A is a perspective view, and Fig. 18B is a sectional view illustrating a part of a section taken along a horizontal plane orthogonal to an outer surface.

Fig. 19 is a photograph illustrating a decorative member used in Example 1.

Fig. 20 is an explanatory diagram briefly illustrating a prototype model formed in each of examples and comparative examples.

Fig. 21 is a graph illustrating a result of line analysis of luminance on a straight line M1 in a prototype model formed in Example 1.

Fig. 22 is a graph illustrating a part of the graph of Fig. 21 in an enlarged manner.

Fig. 23 is a graph illustrating a result of line analysis of luminance on a straight line M2 in the prototype model formed in Example 1.

Fig. 24 is a graph illustrating a part of the graph of Fig. 23 in an enlarged manner.

Fig. 25 is a photograph illustrating a decorative member used in Example 2.

Fig. 26 is a graph illustrating a result of line analysis of luminance on a straight line M1 in a prototype model formed in Example 2.

Fig. 27 is a graph illustrating a part of the graph of Fig. 26 in an enlarged manner.

Fig. 28 is a photograph illustrating a decorative member used in a comparative example.

Fig. 29 is a graph illustrating a result of line analysis of luminance on a straight line M1 in a prototype model formed in the comparative example.

Fig. 30 is a graph illustrating a part of the graph of Fig. 29 in an enlarged manner.

BEST MODE FOR CARRYING OUT THE INVENTION

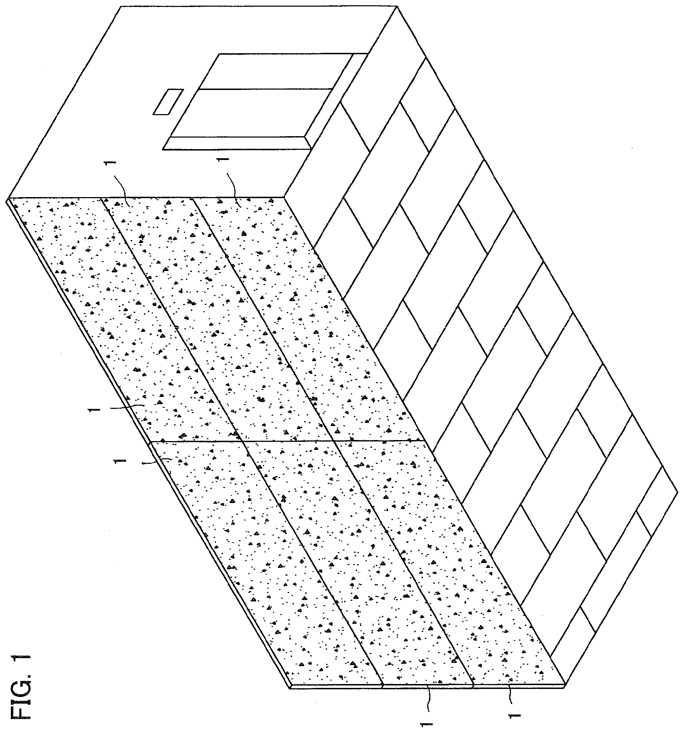

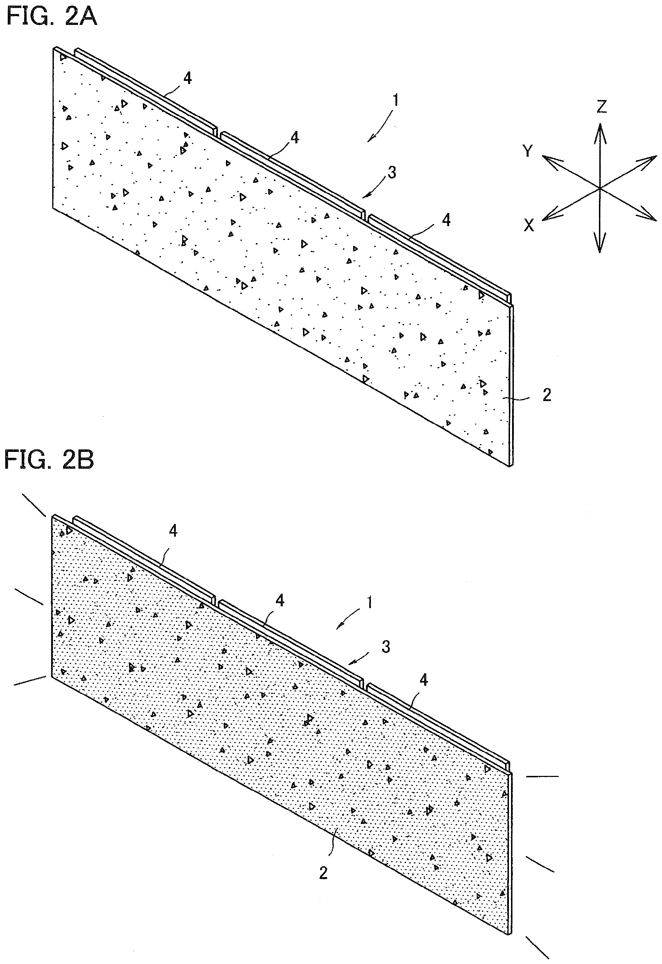

Hereinafter, a building material 1 (light-emitting-device-integrated building material) according to an embodiment of the present invention will be described in detail. In the following description, a longitudinal direction, a vertical direction, and a lateral direction will be described with reference to a normal installation state shown in Fig. 1 unless otherwise specified. Then, the longitudinal direction is also an X direction in Fig. 2, the vertical direction is also a Z direction in Fig. 2, and the lateral direction is also a Y direction in Fig. 2. In addition, regarding the longitudinal direction, a side on which a decorative member 2 forming an external surface is positioned (refer to Fig. 2, etc.) will be described as a front. Thus, unless otherwise specified, a front view in the following description means that a line of sight direction is a direction orthogonal to an outer surface of the decorative member 2 and is a plan view when viewed from the outside.

The building material 1 is a member that can be used as an interior material of a building, and that can be suitably used when a sidewall portion of an entrance, or the like, is formed in an apartment, as illustrated in Fig. 1, for example.

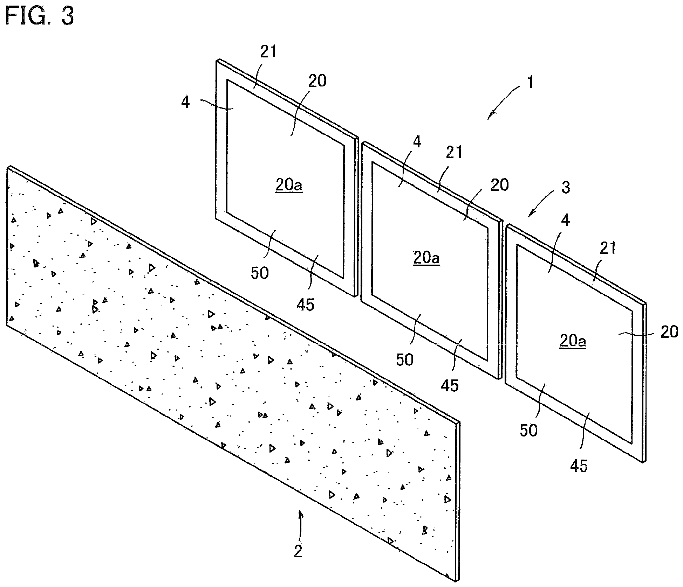

As illustrated in Figs. 2 and 3, the building material 1 has a structure including the decorative member 2 positioned outside (forward) and an inner light emitting section 3 positioned inside (backward).

The decorative member 2 is a translucent member that is as a whole white and exhibits a pattern in which white spots purer than their periphery are irregularly scattered. The term, "translucent" is intended to mean an intermediate point between transparency meaning that light is completely transmitted and non-translucency meaning that light is not completely transmitted.

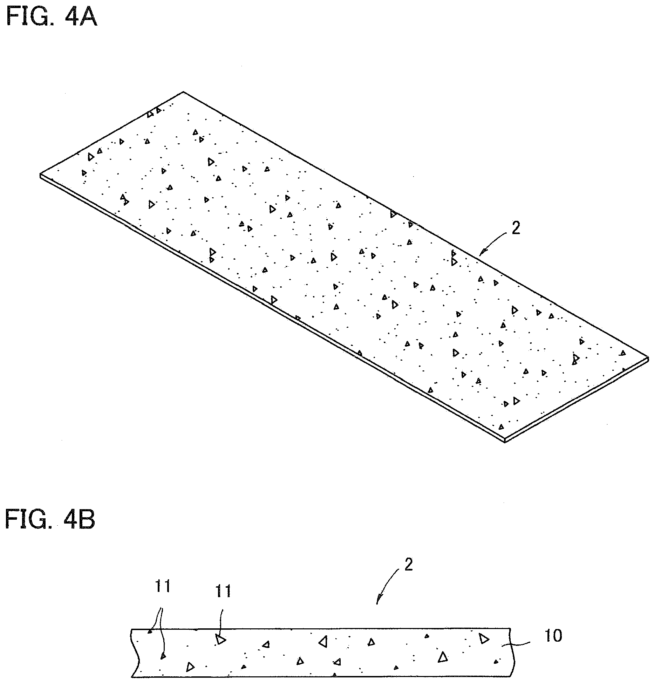

As illustrated in Fig. 4, the decorative member 2 includes a translucent colored layer 10 and granular sections 11 (second portions), and the granular sections 11 are scattered inside the colored layer 10.

For convenience of drawing, in Fig. 4, only some of the granular sections 11 are denoted by reference numerals, and reference numerals to others are omitted.

The colored layer 10 has a refractive index different from that of each of the granular sections 11. Each of the granular sections 11 has a refractive index of 110% or more and 140% or less of the refractive index of the colored layer 10. That is, each of the granular sections 11 has a refractive index of about 125%.

The term, "about" includes an error of a few percent, and the same applies to "about" in description of a proportion described below.

That is, the decorative member 2 has a structure in which the portions (granular sections 11) having different refractive indices from the periphery (colored layer 10) are scattered inside. There is provided the plurality of granular sections 11, and one of the granular sections 11 and another of the granular sections 11, being different in outline or grain size, are mixed. In addition, at least one of the granular sections 11 includes a surface extending in an oblique direction on a part of an external surface as illustrated in Fig. 4B.

The term, "oblique direction" is an oblique direction in a section of the decorative member 2 taken along a plane orthogonal to its outer surface and inner surface. For example, as illustrated in Fig. 4B, the "oblique direction" is a direction inclined with respect to a member-thickness direction and a horizontal direction of the decorative member 2 (the vertical direction and the lateral direction in Fig. 4B) in a cross section taken along the horizontal plane orthogonal to the outer surface and the inner surface. In addition, the "oblique direction" is a direction inclined with respect to each of the member-thickness direction and the vertical direction of the decorative member 2 in a longitudinal section (not illustrated) taken along a vertical plane orthogonal to the outer surface and the inner surface.

That is, at least one of the granular sections 11 has a surface that extends so as to incline with respect to the member-thickness direction of the decorative member 2 and a spreading direction of each of the outer surface and the inner surface of the decorative member 2.

In other words, at least some of the granular sections 11 each are formed to have a surface extending in a direction that is different from the direction orthogonal to the outer surface and the inner surface of the decorative member 2 (the member-thickness direction of the decorative member 2), and that intersects with the outer surface and the inner surface of the decorative member 2.

It is preferable that the decorative member 2 has a thickness (a length in the X direction in Fig. 2) of 3 mm or more and 50 mm or less. A thickness of 5 mm or more and 30 mm or less is more preferable, and a thickness of 7 mm or more and 25 mm or less is even more preferable.

A thickness as described above enables the building material 1 to secure sufficient strength, and enables suppression of a problem caused by excessive increase in thickness of the decorative member 2 (a problem in that design flexibility is impaired or a degree of freedom in design is deteriorated).

As illustrated in Fig. 3, the inner light emitting section 3 is formed by disposing a plurality of planar light emitting devices 4 (surface emitting panels) in parallel, and each of the planar light emitting devices 4 is disposed while its light emitting surface faces forward (outward).

The planar light emitting device 4 is not particularly limited, and an LED panel or an organic EL panel can be suitably used, and in particular, an organic EL panel emitting scattered light is preferable.

In the present embodiment, an organic EL panel is used as the planar light emitting device 4.

That is, the planar light emitting device 4 of the present embodiment has a structure including a panel body 20 having a quadrangular shape when viewed from the front, a circuit board (not illustrated), and a frame member 21.

The panel body 20 is an organic EL device incorporating an organic EL element, and has a structure in which the organic EL element emits light when energized. The organic EL element is configured such that an organic light emitting layer is sandwiched between two opposed electrode layers.

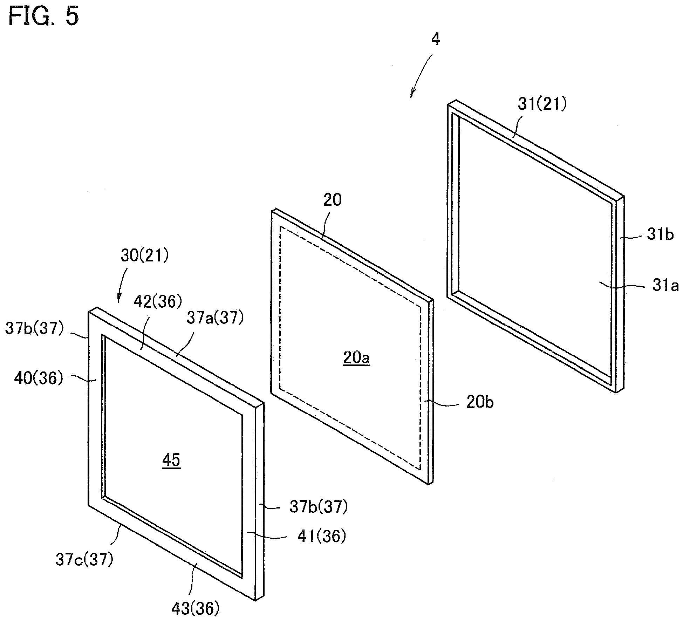

As illustrated in Fig. 5, the panel body 20 has a front surface (outer surface) of a quadrangular shape when viewed from the front, the front surface being divided into a light emitting region 20a positioned on a center side and a peripheral region 20b positioned outside the light emitting region 20a while continuously extending to form a ring shape.

The light emitting region 20a emits light with a desired emission color during lighting, and overlaps with the organic EL element built in the panel body 20 in the member-thickness direction. More specifically, the light emitting region 20a overlaps with a first electrode layer, an organic light emitting layer, and a second electrode layer, of the organic EL element, and serves as a diffused light emitting surface that emits diffused light during lighting.

The light emitting region 20a has a quadrangular shape when viewed from the front, the shape being similar to the shape of the front surface of the panel body 20 when viewed from the front.

The peripheral region 20b is a non-light emitting region that does not emit light even during lighting, and is a region extending continuously in a rectangular ring shape along an edge portion of the panel body 20 when viewed from the front.

The frame member 21 has a structure including a frame member 30 for covering the peripheral region 20b of the panel body 20 from at least a front side of the peripheral region 20b, and a receiving member 31 for covering a rear side of the panel body 20.

The frame member 30 has a structure including a front frame section 36 positioned on a front end side, and a sidewall forming section 37.

The front frame section 36 is a plate-shaped portion extending continuously in a square ring shape such that the shape when viewed from the front is a square shape, and its member-thickness direction is the same as the member-thickness direction of the planar light emitting device 4 (the longitudinal direction).

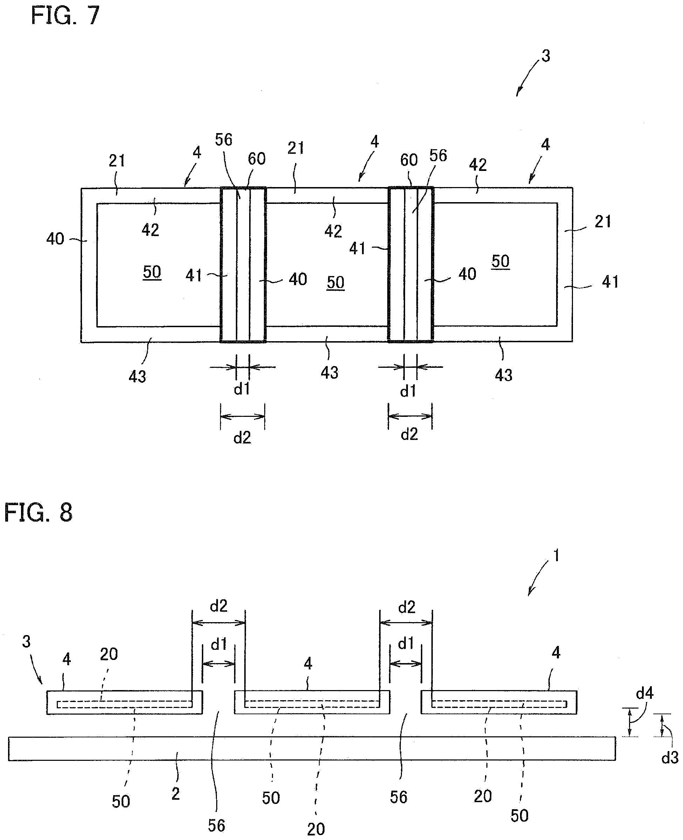

The front frame section 36 has front vertical plate sections 40 and 41 extending in the vertical direction at respective positions apart from each other in the lateral direction. The two front vertical plate sections 40 and 41 each extends between upper and lower ends of the planar light emitting device 4 (refer to Fig. 7, etc.) when the planar light emitting device 4 is viewed from the front. In addition, the front frame section 36 includes one front lateral plate section 42 extending between upper portions of the two front vertical plate sections 40 and 41, and the other front lateral plate section 43 extending between lower portions of the two front vertical plate sections 40 and 41. The two front vertical plate sections 40 and 41, and the two front lateral plate sections 42 and 43, are integrally formed.

From this, a window section 45 for exposing the light emitting region 20a of the panel body 20 is formed in a portion surrounded by the two front vertical plate sections 40 and 41, and the two front lateral plate sections 42 and 43. The window section 45 is a through-hole shaped portion that allows a space on a front side of the front frame section 36 to communicate with a space on a rear side thereof.

The sidewall forming section 37 is a portion in which four plate-shaped bodies protruding rearward from an upper end, both side ends, and a lower end, of the front frame section 36 are integrally formed. That is, the sidewall forming section 37 includes a top plate section 37a extending in the lateral direction at the upper end thereof, and two sidewall sections 37b extending downward from both respective end portions of the top plate section 37a in its longitudinal direction. In addition, the sidewall forming section 37 includes a bottom plate section 37c extending in the lateral direction so as to couple lower end portions of the two respective sidewall sections 37b to each other. The top plate section 37a, the two sidewall sections 37b, and the bottom plate section 37c, are integrally formed.

The receiving member 31 has a bottomed box shape when the entire shape is laid down, and has a structure including a back plate forming section 31a in a quadrangular shape when viewed from the front, and a sidewall forming section 31b.

The back plate forming section 31a is a plate-shaped portion whose member-thickness direction is the same direction (the longitudinal direction) as the member-thickness direction of the planar light emitting device 4.

The sidewall forming section 31b is a portion in which four plate-shaped bodies protruding forward from an upper end, both side ends, and a lower end, of the back plate forming section 31a, are integrally formed.

The planar light emitting device 4 is configured to be formed by attaching the frame member 21 to the panel body 20 such that the panel body 20 and the circuit board (not illustrated) are sandwiched between the frame member 30 and the receiving member 31.

At this time, a connector section (not illustrated) positioned on a back side of the panel body 20 is electrically connected to the circuit board (not illustrated), and the connector section of the circuit board is positioned near a power supply hole (not illustrated) formed in the back plate forming section 31a. This enables a power supply cable to be inserted into the connector section of the circuit board from a rear side of the back plate forming section 31a. When a power supply cable is inserted, electric power can be supplied to the panel body 20 from the outside via the circuit board. In addition, when the panel body 20 and the circuit board are connected to each other, the circuit board can control light modulation or the like of an organic EL element.

As illustrated in Fig. 3, the planar light emitting device 4 formed as described above includes a portion where the light emitting region 20a is exposed from the window section 45, the portion serving as a light emitting section 50 that emits light during lighting. Then, the other portion serves as a non-light emitting section that does not emit light by itself.

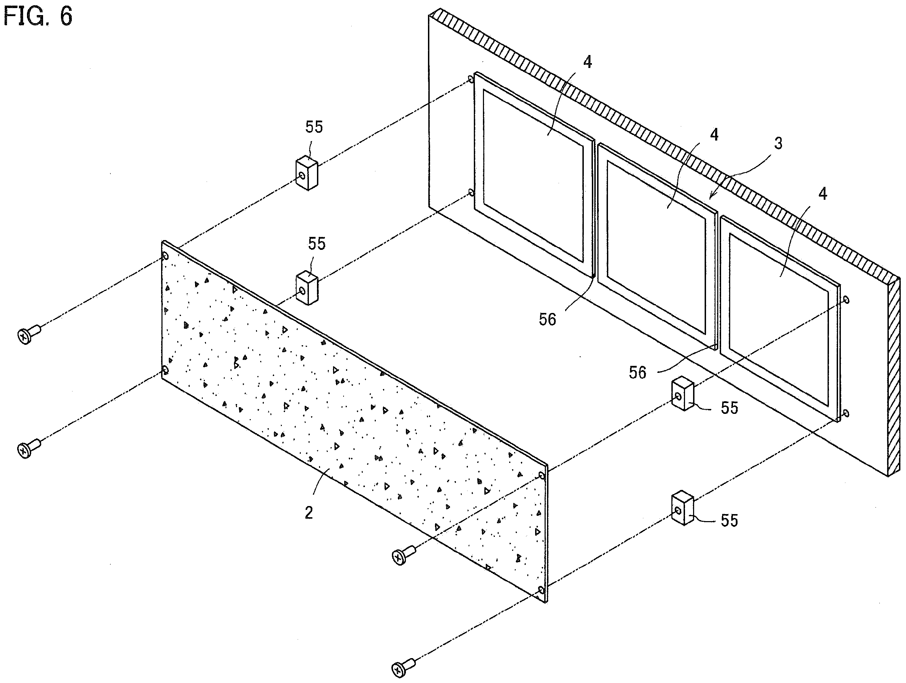

Here, a mounting method for attaching the building material 1 of the present embodiment to a mounting surface of a structure will be described with reference to Fig. 6.

First, one or more panel mounting fixtures (not illustrated) are fixed to a target mounting surface, and a step of fixing the planar light emitting device 4 to the mounting fixture is performed. Through this step, a plurality (three) of the planar light emitting devices 4 is disposed in parallel to form the inner light emitting section 3.

In this step, a wiring work for connecting various wires such as a power supply cable to the planar light emitting devices 4 provided in the inner light emitting section 3 is performed. In the present embodiment, the three planar light emitting devices 4 provided in the inner light emitting section 3 are electrically connected in series by an electrical connection member (not illustrated) such as a connection cable, so that power supply to one of the planar light emitting devices 4 enables power supply to all of the planar light emitting devices 4.

Next, a step of fixing the decorative member 2 to the front of the planar light emitting device 4 is performed. Upon completion of the step of mounting the decorative member 2, assembly of the building material 1 is completed.

In the step of fixing the decorative member 2, before performing this step, a step of forming mounting holes in the decorative member 2 is preliminarily performed. The mounting holes are formed at a respective plurality of places (two places) apart from each other in the vertical direction on each of end sides in the lateral direction of the decorative member 2. This mounting hole is a through hole passing through the decorative member 2 in its member-thickness direction.

While a spacer member 55 is disposed between the decorative member 2 and the mounting surface of the structure, a fastening element is inserted so as to pass through the decorative member 2 and the spacer member 55. This allows the decorative member 2 to be fixed to the mounting surface of the structure.

The fastening element is a generic concept of screws, nails, bolts, and the like.

As described above, in the present embodiment, the inner light emitting section 3 is formed by disposing the three planar light emitting devices 4 in parallel. Thus, the decorative member 2 is disposed outside the portion across the three planar light emitting devices 4, and the three different portions overlap with the respective planar light emitting devices 4 in an inside-outside direction.

As illustrated in Fig. 7, the inner light emitting section 3 includes an inter-panel space 56 that is formed between the two planar light emitting devices 4 adjacent to each other in a parallel direction (lateral direction). That is, the two planar light emitting devices 4 are disposed at an interval, and the inter-panel space 56 is a gap formed in the interval portion.

The inner light emitting section 3 has a structure that includes a portion that emits light by itself during lighting, and a portion that does not emit light by itself.

More specifically, the inner light emitting section 3 emits light from its outer portion (front portion) facing the decorative member 2, and in detail, the light emitting section 50 in each of the planar light emitting devices 4 emits light. Meanwhile, even in the portion of the inner light emitting section 3 facing the decorative member 2 (the front portion), a portion where the frame member 21 is positioned and a portion where the inter-panel space 56 is positioned do not emit light by themselves.

Thus, when the inner light emitting section 3 is viewed from the front, it can be divided into a region where the light emitting section 50 is positioned, and that emits light by itself, and a region where the frame member 21 or the inter-panel space 56 is positioned, and that does not emit light by itself. At this time, in the two planar light emitting devices 4 adjacent to each other in the parallel direction, a portion positioned between the light emitting section 50 of one of the planar light emitting devices 4 and the light emitting section 50 of the other of the planar light emitting devices 4 serves as a region that does not emit light by itself.

That is, the front vertical plate section 40 of the one of the planar light emitting devices 4, which is adjacent to the inter-panel space 56, and the inter-panel space 56, and the front vertical plate section 41 of the other of the planar light emitting devices 4, which is adjacent to the inter-panel space 56, each serve as a portion that does not emit light by itself.

As a result, when the inner light emitting section 3 is viewed from the front, portions where the front vertical plate section 40 of the one of the planar light emitting devices 4, the inter-panel space 56, and the front vertical plate section 41 of the other of the planar light emitting devices 4, are positioned, the portions being continuously integrated, serve as an inter-panel non-light emitting region 60 that does not emit light by itself.

Here, a length $d1$ of the inter-panel space 56 in its width direction is preferably 0 mm or more and 10 mm or less, more preferably 0.1 mm or more and 5 mm or less, and still more preferably 0.2 mm or more and 3 mm or less.

A length d2 of the inter-panel non-light emitting region 60 in its width direction is preferably 1 mm or more and 30 mm or less, more preferably 2 mm or more and 20 mm or less, and still more preferably 3 mm or more and 10 mm or less.

The width direction of each of the inter-panel space 56 and the inter-panel non-light emitting region 60 is also in the lateral direction (the lateral direction in Fig. 7) and is the same as the parallel direction of the planar light emitting devices 4.

As illustrated in Fig. 8, in the present embodiment, the decorative member 2 is positioned at a position away forward (outward) from the inner light emitting section 3 (each of the planar light emitting devices 4).

An outer surface (front surface) of the panel body 20 of each of the planar light emitting devices 4 provided in the inner light emitting section 3 and an inner surface (rear surface) of the decorative member 2 are parallel to each other.

In addition, an outer end surface (front surface) of the frame member 21 of each of the planar light emitting devices 4 provided in the inner light emitting section 3 and the inner surface (the rear surface) of the decorative member 2 are also parallel to each other.

The outer end surface (front side end surface) of the frame member 21 of the planar light emitting device 4 is an outer surface (front side surface) of the front frame section 36 (refer to Fig. 5, etc.).

At this time, a distance d3 between the planar light emitting device 4 and the decorative member 2 is preferably 0 mm or more and 10 mm or less, more preferably 1 mm or more and 8 mm or less, and still more preferably 2 mm or more and 7 mm or less.

The "distance d3 between the planar light emitting device 4 and the decorative member 2" described above is specifically the distance d3 from the outer end surface of the planar light emitting device 4 to the inner surface of the decorative member 2.

A distance d4 from the light emitting section 50 (the outer surface of the panel body 20) of the planar light emitting device 4 to the inner surface of the decorative member 2 is preferably 0.1 mm or more and 10 mm or less, more preferably 2.5 mm or more and 8 mm or less. The distance d4 is still more preferably 3 mm or more and 6 mm or less.

In other words, a gap is formed between the inner light emitting section 3 and the decorative member 2, or a layer of air is formed. The layer of air has a refractive index different from a refractive index of the decorative member 2 described above. That is, in a direction from the inside to the outside of the building material 1, the layer of air and the colored layer 10 described above are disposed so as to continuously extend, and the refractive indices of the respective layers are different from each other. In addition, in part, the layer of air, the colored layer 10, and the granular section 11, are disposed so as to continuously extend in the direction from the inside to the outside of the building material 1. In this case, the refractive indices of the respective sections are also different from each other.

More specifically, the distance d4 from the light emitting section 50 (the outer surface of the panel body 20) of the planar light emitting device 4 to the inner surface of the decorative member 2 is preferably 50% or more and 200% or less of the length d2 of the inter-panel non-light emitting region 60 in its width direction described above, and is preferably about 100%.

The building material 1 of the present embodiment is formed such that a value of X1 in the following expression (A) is 55 or more and 3000 or less (condition (1)). In the following expression, an average value of luminance per unit area of the inter-panel non-light emitting region 60 when viewed from the front is indicated as A1. Then, an average value of luminance in a portion of the outer surface of the decorative member 2, the portion overlapping with the inter-panel non-light emitting region 60 in the longitudinal direction, is indicated as A2.

$$X1 = (A2/A1) * 100 - 100 \ ... \ (A)$$

In addition, the building material 1 has a value of X2 in the following expression (B) of 1.5 or more and 100 or less (condition (2)). In the following expression, an outer surface of each of the two light emitting sections 50 disposed adjacent to the inter-panel non-light emitting region 60 to be measured for the above A1 is defined as a reference light emitting surface, and an average value of luminance per unit area of the reference light emitting surface is indicated as A3.

$$X2 = ((A2 - A1)/A3) * 100 \ ... \ (B)$$

In addition, the building material 1 of the present embodiment is formed such that the value of X1 described above is to be 55 or more and 3000 or less, more preferably 350 or more and 3000 or less. It is still more preferable that the building material 1 is formed such that the value of X1 is to be 800 or more and 3000 or less.

While the building material 1 of the present embodiment is formed such that the value of X2 described above is to be 1.5 or more and 100 or less, more preferably the value of X2 is to be 6 or more and 100 or less, and still more preferably 15 or more and 100 or less.

More specifically, when "an average value of luminance per unit area of the inter-panel non-light emitting region 60 when viewed from the front" is calculated, the entire region of the inter-panel non-light emitting region 60 viewed from the front is to be measured. Then, an average value of luminance at a plurality of measurement points is calculated, the measurement points being set at a plurality of places in outer end surfaces of the two respective front vertical plate sections 40 and 41, and in an outer end portion of the inter-panel space 56 positioned between the front vertical plate sections 40 and 41.

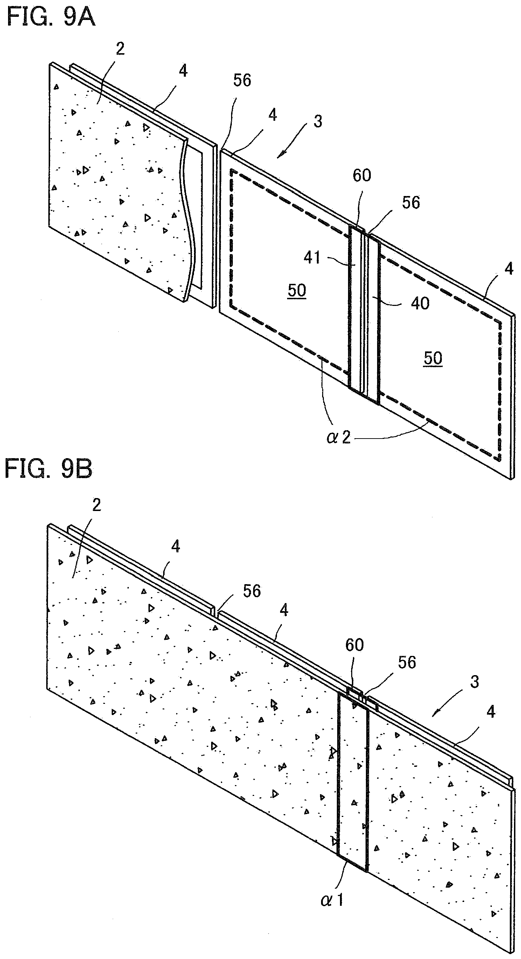

During the measurement, the decorative member 2 is not disposed outside the inter-panel non-light emitting region 60. That is, measurement is performed in the state illustrated in Fig. 9A.

The number of measurement points is set to a predetermined number n1 (n1 is a value that is a sufficient number of times to offset a measurement error or a bias of luminance and to obtain an average value accurately).

Each of the measurement points is to be evenly distributed over the entire area of the outer end surface of each of the two front vertical plate sections 40 and 41, and of the outer end portion of the inter-panel space 56.

When measurement at each of the measurement points is performed, the measurement is performed assuming that various measurement conditions, such as a positional relationship between the measurement point and the measuring instrument (luminance meter), are identical.

When "an average value of luminance in a portion of the outer surface of the decorative member 2, the portion overlapping with the inter-panel non-light emitting region 60 in the longitudinal direction" is calculated, a part of the outer surface of the decorative member 2, the part being positioned outside the inter-panel non-light emitting region 60 to be measured for the A1, is to be measured. In other words, when the inter-panel non-light emitting region 60 to be measured for the A1 is projected on the outer surface of the decorative member 2, the entire area of a portion overlapping with a projection plane is be measured (a range indicated by $\alpha 1$ in Fig. 9B, hereinafter also referred to as a projection plane overlapping region $\alpha 1$).

Then, a plurality of points in the projection plane overlapping region $\alpha 1$ are set as measurement points, and an average value of luminance at the plurality of measurement points is calculated.

It is a matter of course that the measurement is performed while the decorative member 2 is disposed outside the inter-panel non-light emitting region 60 as in the state illustrated in Fig. 9B.

The number of measurement points is set to a predetermined number n1 (n1 is a value that is a sufficient number of measurement times to offset a measurement error or a bias of luminance and to obtain an average value accurately).

Each of the measurement points is to be evenly distributed over the entire area of the projection plane overlapping region $\alpha 1$.

When measurement at each of the measurement points is performed, the measurement is performed assuming that various measurement conditions, such as a positional relationship between the measurement point and the measuring instrument (luminance meter), are identical.

When "an average value of luminance per unit area of the reference light emitting surface" is calculated, an outer surface of each of the two light emitting sections 50 disposed adjacent to the inter-panel non-light emitting region 60 to be measured for the A1 is defined as a reference light emitting surface, and the reference light emitting surface is to be measured. That is, the entire area (the range indicated by $\alpha 2$ in Fig. 9A) of each of the outer surfaces of the two respective light emitting sections 50 disposed adjacent to the inter-panel non-light emitting region 60 is to be measured.

Then, a plurality of points on both outer surfaces (reference light emitting surfaces) of the two light emitting sections 50 are set as measurement points, and an average value of luminance at a plurality of measurement points is calculated.

During the measurement, the decorative member 2 is not disposed outside the inter-panel non-light emitting region 60. That is, measurement is performed in the state illustrated in Fig. 9A.

The number of measurement points is set to a predetermined number n1 (n1 is a value that is a sufficient number of times to offset a measurement error or a bias of luminance and to obtain an average value accurately).

Each of the measurement points is to be evenly distributed over the entire area of the outer surface of one of the light emitting sections 50 and the entire area of the outer surface of the other of the light emitting sections 50.

When measurement at each of the measurement points is performed, the measurement is performed assuming that various measurement conditions, such as a positional relationship between the measurement point and the measuring instrument (luminance meter), are identical.

In addition, when the A1 is measured, a portion that does not emit light by itself, of the inner light emitting section 3, is to be measured, and measurement is performed while the decorative member 2 is removed.

When the A2 is measured, a part of the decorative member 2 that overlaps with a portion that does not emit light by itself, of the inner light emitting section 3, is to be measured, and measurement is performed while the inner light emitting section 3 is covered with the decorative member 2.

When the A3 is measured, a portion that emits light by itself, of the inner light emitting section 3, is to be measured, and measurement is performed while the decorative member 2 is removed.

As described above, the building material 1 with a structure that satisfies the condition (1) described above, and that preferably satisfies the condition (2), can prevent a significantly outstanding dark portion from being formed in an outer surface of the decorative member 2 during lighting of the inner light emitting section 3 (refer to Fig. 2B).

In other words, when the inter-panel non-light emitting region 60 is projected onto the outer surface of the decorative member 2, it is possible to prevent a portion overlapping with a projection plane (projection plane overlapping region $\alpha$1) from becoming extremely darker than its periphery. This enables the building material 1 with a beautiful appearance to be provided.

More specifically, the building material 1 with a structure that satisfies the condition (1) described above, and that preferably satisfies the condition (2), a part of scattered light emitted from the light emitting section 50 of the planar light emitting device 4 reaches between the decorative member 2 and the inter-panel non-light emitting region 60. The amount and the intensity of the light reaching between the decorative member 2 and the inter-panel non-light emitting region 60 are sufficient to the extent that the projection plane overlapping region $\alpha$1 does not become extremely darker than its periphery.

According to the structure of the building material 1 of the present embodiment, the light emitted from the planar light emitting device 4 can be scattered efficiently and the entire area of the external surface of the decorative member 2 can be made sufficiently bright.

In the building material 1 according to the embodiment described above, machining of forming a groove recessed outward in the inner surface of the decorative member 2 may be performed.

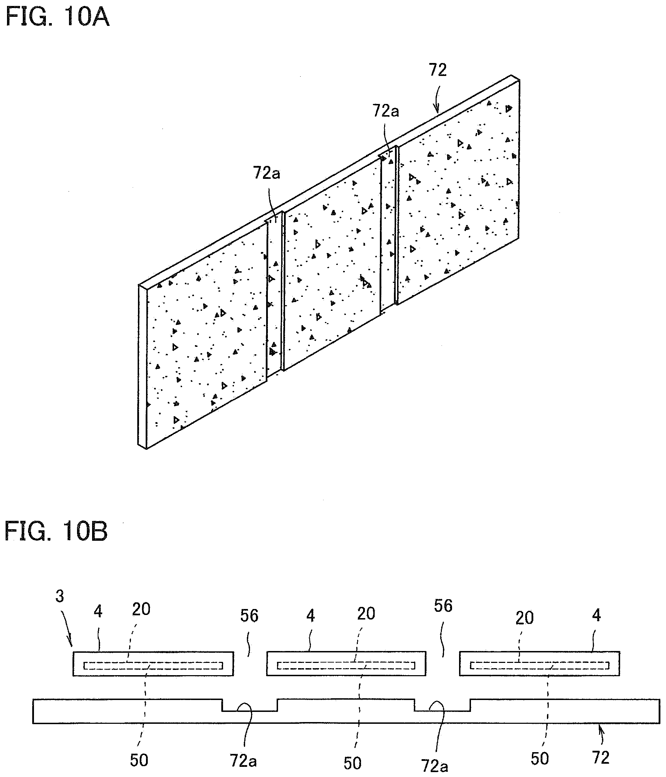

For example, as illustrated in Fig. 10A, a groove section 72a extending in the vertical direction may be formed in an inner surface of a decorative member 72. Then, as illustrated in Fig. 10B, the decorative member 72 may be attached such that the groove section 72a is positioned at a position overlapping with the inter-panel non-light emitting region 60 (refer to Fig. 9A) in the longitudinal direction (the inside-outside direction).

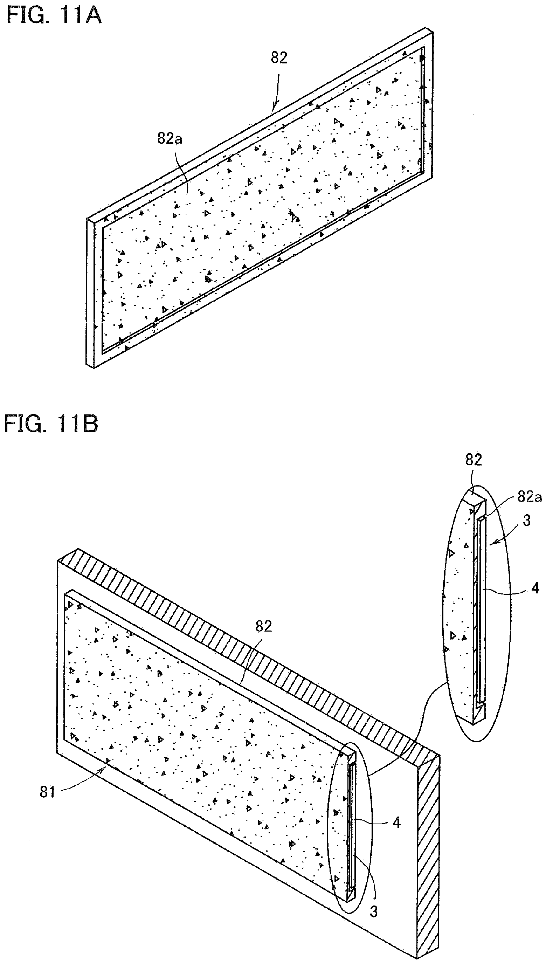

In addition, as illustrated in Fig. 11A, a recessed portion 82a capable of housing at least a part of the inner light emitting section 3 may be formed in an inner surface of a decorative member 82.

As illustrated in Fig. 11B, the recessed portion 82a is a portion recessed outward, and is a portion capable of housing the entire inner light emitting section 3. That is, in a building material 81 (light-emitting-device-integrated building material) using the decorative member 82, the decorative member 82 surrounds outside of the upper and lower sides, and both of the side ends of the inner light emitting section 3. The recessed portion 82a may be formed so as to have a shallower depth (length in the longitudinal direction) to house only a part of an outer side of the inner light emitting section 3 while the other portion thereof positioned on a mounting surface side to the structure is not housed.

It is preferable to apply surface treatment to the inner surface of the decorative member 2. For example, blasting may be applied to the inner surface of the decorative member 2, or silica powder may be attached to the inner surface of the decorative member 2. Applying surface treatment as described above enables light emitted from the planar light emitting device 4 to be more efficiently scattered.

In the above embodiment, there is described an example in which the three planar light emitting devices 4 are disposed in parallel to form the inner light emitting section 3, and the present invention is not limited thereto. Four or more planar light emitting devices 4 may be disposed in parallel to form an inner light emitting section, and two planar light emitting devices 4 may be disposed in parallel to form an inner light emitting section.

As described above, an inner light emitting section may be formed by disposing the planar light emitting devices 4 in parallel not only in the horizontal direction, but also in the vertical direction. That is, the planar light emitting devices 4 may be disposed in parallel in a matrix in the vertical direction and the horizontal direction. Thus, the inter-panel non-light emitting region 60 described above may be formed by two planar light emitting devices 4 disposed in parallel in the vertical direction.

In addition, while the structure in which one decorative member 2 is disposed outside the inner light emitting section 3 is described in the above embodiment, a structure in which a plurality of decorative members are disposed outside the inner light emitting section 3 may be used.

At this time, a decorative member having a smaller area than that of the above decorative member 2, when viewed form the front, may be used and disposed in parallel in the vertical direction or the horizontal direction. Likewise, the decorative member may be disposed in a matrix when viewed from the front. That is, a plurality of decorative members may be disposed in parallel to function as a single decorative member.

In the above embodiment, while there is described an example in which the plurality (three) of planar light emitting devices 4 are electrically connected in series, the planar light emitting devices 4 may be electrically connected in parallel. However, it is more preferable to electrically connect them in series from the viewpoint of forming a beautiful appearance without causing luminance unevenness in the entire area of the building material 1.

In the above embodiment, there is described an example in which the planar light emitting device 4 is formed while the panel body 20 and the circuit board (not illustrated) are sandwiched between the frame member 21 (the frame member 30 and the receiving member 31). Then, the planar light emitting device 4 formed as described above is fixed to a wall surface with a panel mounting fixture (not illustrated).

However, the present invention is not limited to such a structure.

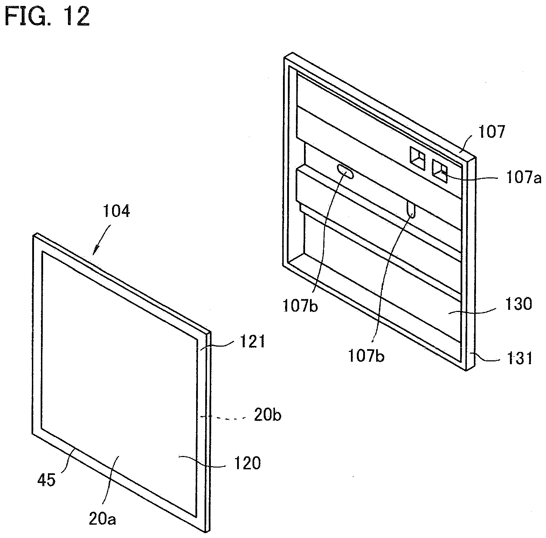

For example, as illustrated in Fig. 12, there may be a structure in which a planar light emitting device 104 (surface emitting panel) with no built-in circuit board is fixed to a wall surface using a mounting fixture 107 with a built-in circuit board.

The planar light emitting device 104 uses a frame member 121 that is formed such that at least a back surface, an end surface, and a peripheral region 20b (refer to Fig. 5) of a panel body 120 are covered therewith from the outside. Similar to the frame member 21 described above, a window section 45 for exposing a light emitting region 20a is also formed on a front side of the frame member 121.

The panel body 120 used in the planar light emitting device 104 has a structure similar to that of the panel body 20 on the light emitting surface side, and has a structure including the light emitting region 20a and the peripheral region 20b.

On a back surface side of the panel body 120, there are provided an anode pad and a cathode pad respectively having the same potential as that of an anode and a cathode of a built-in organic EL element.

In the frame member 121, a portion constituting a part of the back surface of the planar light emitting device 104 is provided with a panel-side connector section (not illustrated) that engages with a fixture-side connector section 107a (described in detail below) of the mounting fixture 107.

When the planar light emitting device 104 is formed, the anode pad and the cathode pad of the panel body 120, and the panel-side connector section of the frame member 121, are electrically connected to each other. That is, these are electrically connected by a conductive member (not illustrated) disposed between the panel body 120 and the frame member 121. Thus, when electric power is supplied to the panel-side connector section (not illustrated) of the frame member 121 from the outside, the organic EL device can be energized.

The mounting fixture 107 is a member in the shape of a bottomed box when laid down, and has a structure including a back wall section 130 positioned on its back surface side and a sidewall section 131. The sidewall section 131 is formed by plate-shaped portions protruding forward from an upper side, one of end sides in the lateral direction, the other of the end sides in the lateral direction, and a lower side, of the back wall section 130, the plate-shaped portions being continuously formed in a ring shape. That is, flat plate-shaped portions extending in the lateral direction are disposed at two respective positions apart from each other in the vertical direction, and flat plate-shaped portions extending in the vertical direction are disposed at two respective positions apart from each other in the lateral direction. The two flat plate-shaped portions extending in the lateral direction and the two flat plate-shaped portions extending in the vertical direction extend continuously to form a rectangular ring shape when viewed from the front.

The back wall section 130 is provided with the fixture-side connector section 107a and a mounting hole 107b. More specifically, the back wall section 130 has a structure including a relatively thick portion and a relatively thin portion. The relatively thick portion is provided in its inside with a built-in control board and the fixture-side connector section 107a. The relatively thin portion is provided with the mounting hole 107b.

The fixture-side connector section 107a can be electrically connected to the panel-side connector section (not illustrated) formed in a back surface of the frame member 121.

That is, when the planar light emitting device 104 is attached to the mounting fixture 107, the panel-side connector section of the planar light emitting device 104 and the fixture-side connector section 107a of the mounting fixture 107 can be electrically connected to each other. As a result, when electric power is supplied to the mounting fixture 107 from the outside, power is supplied to the planar light emitting device 104.

The supply of electric power to the mounting fixture 107 from the outside can be performed by connecting a power supply member such as a power supply cable to a power supply unit (not illustrated) such as a cable connection hole formed in a back surface side of the back wall section 130, or at least one of an upper surface, an outer side-surface, and a lower surface, of the back wall section 130.

The mounting hole 107b is a through hole passing through the back wall section 130. A plurality of mounting holes 107b are formed one by one at two respective places apart from each other in the lateral direction, at a substantially identical height, in the back wall section 130.

One of the mounting holes 107b is a vertically elongated hole extending in the vertical direction, and the other is a laterally elongated hole extending in the lateral direction.

When the planar light emitting device 104 as described above is fixed to a target wall surface, first, the mounting fixture 107 is fixed to the target wall surface. That is, the mounting fixture 107 is disposed at a mounting position, and a fastening element such as a bolt is inserted into the mounting hole 107b to fix the mounting fixture 107 to the wall surface. Then, the planar light emitting device 104 is fitted into a recessed section of the mounting fixture 107 fixed to the wall surface to fix the planar light emitting device 104 to the mounting fixture 107.

Next, the decorative member 2 is fixed to the outside of the plurality of planar light emitting devices 104 attached as described above to form a building material.

In the embodiment described above, while there is described an example in which the plurality of planar light emitting devices 4 are disposed in parallel such that the inter-panel space 56 is formed between one of the planar light emitting devices 4 and the other adjacent planar light emitting device 4 to form the inner light emitting section 3, the present invention is not limited to this example.

For example, when the plurality of planar light emitting devices 4 are disposed in parallel, the planar light emitting devices 4 may be disposed such that the inter-panel space 56 is not formed between the two planar light emitting devices 4 adjacent to each other in the parallel direction. A building material 201 (light-emitting-device-integrated building material) of an embodiment different from the above embodiment will be described in detail below.

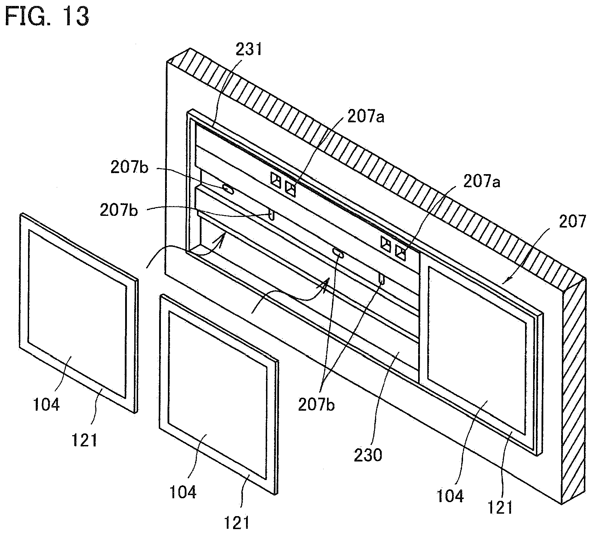

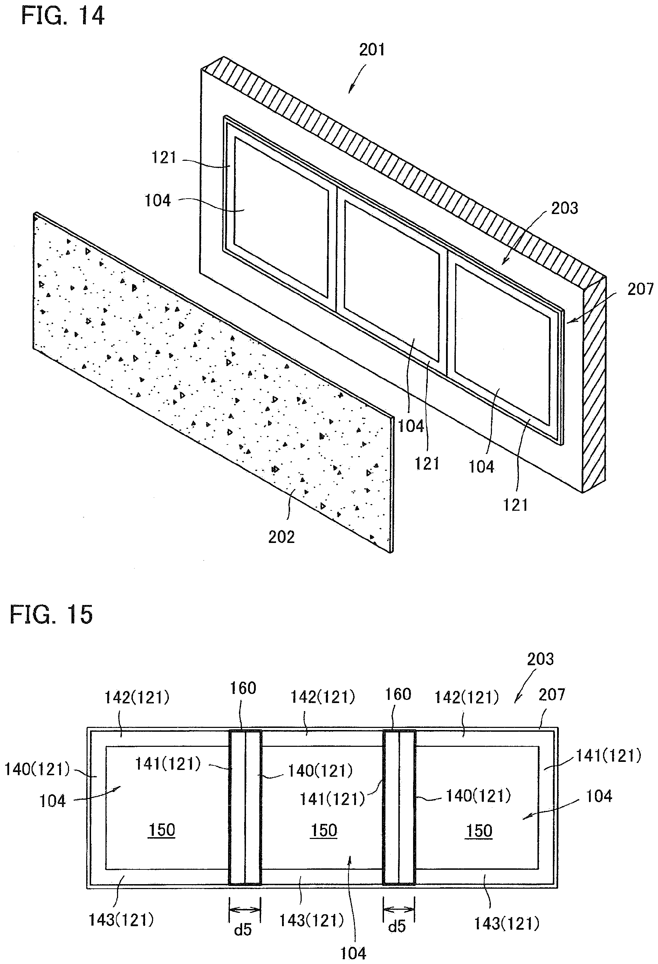

As illustrated in Figs. 13 and 14, the building material 201 of the present embodiment is configured such that a plurality of planar light emitting devices 104 are fixed to one mounting fixture 207 (panel mounting member) previously fixed to the wall surface to form an inner light emitting section 203. Then, a decorative member 202 is fixed to outer portions of the mounting fixture 207 and the inner light emitting section 203 with a transparent adhesive or the like to form the building material 201.

As illustrated in Fig. 13, the mounting fixture 207 is formed in a shape having a length in a horizontal direction (a lateral direction, and a parallel direction of the planar light emitting devices 104) when viewed from the front, the length being more than that of the above mounting fixture 107, so that the plurality of planar light emitting devices 104 can be attached. Similar to the above mounting fixture 107, the mounting fixture 207 is provided with a back wall section 230 positioned on its back side and a sidewall section 231, and a recessed section recessed backward (inward) is formed.

Similar to the mounting fixture 107 described above, a fixture-side connector section 207a and a mounting hole 207b are formed in the back wall section 230. In addition, a control board is built in a relatively thick portion of the back wall section 230.

In the mounting fixture 207, a plurality of fixture-side connector sections 207a are formed on the back wall section 230, and the plurality of fixture-side connector sections 207a are disposed in parallel apart from each other in a lateral direction at respective potions each at a substantially identical height.

The mounting fixture 207 of the present embodiment allows three planar light emitting devices 104 to be attached, and the fixture-side connector sections 207a are also formed at three respective places. In other words, the fixture-side connector sections 207a are formed by the number same as the number of planar light emitting devices 104 that can be attached. When a panel-side connector section (not illustrated) formed on a back surface of each of the planar light emitting devices 104 is electrically connected to the corresponding one of the fixture-side connector sections 207a, electric power is supplied to each of the planar light emitting devices 104. That is, electric power can be supplied to the plurality of planar light emitting devices 104 by supplying power to one of the mounting fixtures 207.

The mounting hole 207b is a through hole passing through the back wall section 230, and a plurality of the mounting holes 207b are formed so as to be disposed in parallel at intervals in the lateral direction at respective positions each at a substantially identical height. At least one of the plurality of mounting holes 207b is a vertically elongated hole extending in the vertical direction and at least the other thereof is a laterally elongated hole extending in the lateral direction.

The mounting fixture 207 includes the recessed section into which the plurality (three) of planar light emitting devices 104 can be fitted.

More specifically, as illustrated in Figs. 13 and 14, the planar light emitting devices 104 are fitted such that an edge portion of one of the planar light emitting devices 104 disposed adjacent to each other and an edge portion of the other of the planar light emitting devices 104 are brought into contact with each other.

Specifically, as illustrated in Fig. 15, the frame member 121 of the planar light emitting device 104 also includes two front vertical plate sections 140 and 141 for covering the peripheral region 20b of the panel body 120 from the outer side (front side), and two front lateral plate sections 142 and 143.

The two front vertical plate sections 140 and 141, and the two front lateral plate sections 142 and 143, extend continuously in a square ring shape when viewed from the front, and a member-thickness direction of each of the portions is the same as a member-thickness direction of the planar light emitting device 104.

Thus, when viewed from the front, a window-shaped portion is formed in a portion surrounded by the two front vertical plate sections 140 and 141, and the two front lateral plate sections 142 and 143, by holes communicating through the inside and outside of the frame member 121. Then, the light emitting region 20a of the panel body 120 is exposed to the outside through the window-shaped portion to form a light emitting section 150.

When three planar light emitting devices 104 are attached to the mounting fixture 207 to form the inner light emitting section 203 by disposing the three planar light emitting devices 104 in parallel in the lateral direction, each of the inner light emitting sections 203 serves as the light emitting section 150 that emits light by itself. That is, when viewed from the front, the inner light emitting section 203 is divided into a portion that emits light by itself and a portion that does not emit light by itself, during lighting. At this time, each of the light emitting sections 150 serves as a portion that emits light by itself, and a portion where the frame member 121 is positioned serves as a portion that does not emit light by itself.

The two planar light emitting devices 104 disposed adjacent to each other are disposed such that a side surface of one frame member 121 and a side surface of the other frame member 121 are brought into contact with each other. Thus, one front vertical plate section 140 and the other front vertical plate section 141 are disposed adjacent to a boundary portion between the two planar light emitting devices 104.

As described above, the boundary portion between the two planar light emitting devices 104, and a portion where the front vertical plate section 140 of the one planar light emitting device 104 and the front vertical plate section 141 of the other planar light emitting device 104 are each positioned, each serve as a portion that does not emit light by itself.

That is, when the inner light emitting section 203 is viewed from the front, the boundary portion between the two planar light emitting devices 104 and a portion where the two front vertical plate sections 140 and 141 disposed adjacent to each other integrally extend continuously serve each as an inter-panel non-light emitting region 160 that does not emit light by itself.

A length d5 (length in the lateral direction and in the parallel direction of the planar light emitting devices 104) of the inter-panel non-light emitting region 160 in a width direction is preferably 1 mm or more and 30 mm or less, more preferably 2 mm or more and 20 mm or less. The length d5 is still more preferably 3 mm or more and 10 mm or less.

The building material 201 of the present embodiment is also configured to have a structure that satisfies the above condition (1), and that more preferably satisfies the condition (2). This allows a part of scattered light emitted from the light emitting section 50 of the planar light emitting device 104 to reach between the decorative member 202 and the inter-panel non-light emitting region 160. The amount and the intensity of the light reaching between the decorative member 202 and the inter-panel non-light emitting region 160 are sufficient to the extent that the projection plane overlapping region described above does not become extremely darker than its periphery.

In the above embodiment, while the inter-panel non-light emitting region 160 is formed by bringing the side surfaces of the two respective planar light emitting devices 104, disposed adjacent to each other, into contact with each other, a gap may be formed between the two planar light emitting devices 104.

That is, the gap may be formed between the side surfaces of the two respective planar light emitting devices 104 by forming the mounting fixture 207 with a longer length in its lateral direction to change a position of the fixture-side connector section 207a. Then, the formed gap may be filled with a resin such as a transparent adhesive. In other words, the gap included in the inter-panel non-light emitting region may be filled with a resin or the like.

In each of the above embodiments, it is preferable to apply mirror finishing to the outer surfaces of the two respective front vertical plate sections 40 and 41 (or the two front vertical plate sections 140 and 141) in the inter-panel non-light emitting region 60 (or the inter-panel non-light emitting region 160).

For example, when the frame member 21 (or the frame member 121) is made of a metal material such as aluminum, it is preferable to perform surface treatment (mirror finishing) to improve reflectance of an outer surface of the frame member 21, such as polishing the outer surfaces of the two respective front vertical plate sections 40 and 41. Accordingly, when the inner light emitting section 3 (or the inner light emitting section 203) is lit, it is possible to make the inter-panel non-light emitting region 60 (or the inter-panel non-light emitting region 160) and its vicinity brighter.

At this time, at least a part of the outer surfaces of the two respective front vertical plate sections 40 and 41 may be subjected to surface treatment, or the entire outer surface may be subjected to the surface treatment. However, from a viewpoint of making it brighter, it is preferable that the surface treatment is applied to the entire surface to form a reflecting surface that reflects light.

Instead of a structure in which mirror finishing is applied to the outer surfaces of the respective front vertical plate sections 40 and 41 (or the two respective front vertical plate sections 140 and 141), a thin plate-shaped member or a film-shaped member may be attached to the outer surfaces of the respective front vertical plate sections 40 and 41.

At this time, reflectance of a surface positioned outside the thin plate-shaped member or the film-shaped member is to be higher than reflectance of the outer surface of each of the front vertical plate sections 40 and 41.

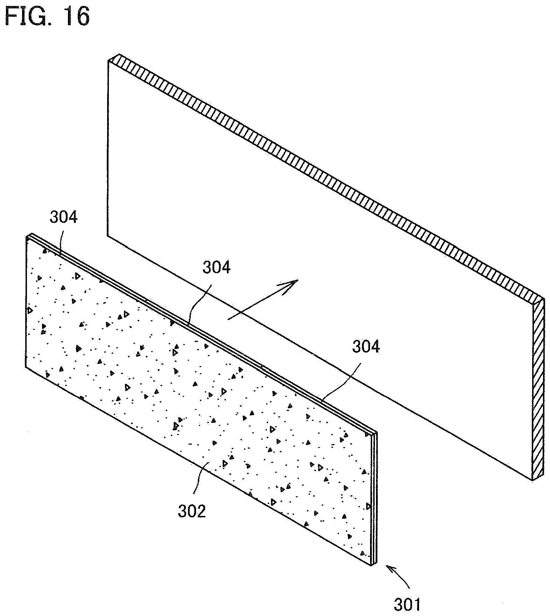

In addition, as illustrated in Fig. 16, a building material 301 (light-emitting-device-integrated building material) in which a planar light emitting device 304 (surface emitting panel) is preliminarily fixed to an inner surface of a decorative member 302 may be formed. The building material 301 may be configured to be fixed to a building material mounting fixture (not illustrated) previously fixed to a wall surface. That is, a portion of an inner surface of the building material 301, the portion being formed by an inner surface of the planar light emitting device 304, may be fixed to the building material mounting fixture.

At this time, instead of the planar light emitting device 304, the panel body 20 may be directly fixed to an inner surface of the decorative member 302, for example. In this case, the light emitting region 20a of the panel body 20 may be brought into contact with the inner surface of the decorative member 302. In other words, the entire area of the light emitting region 20a of the panel body 20 may serve as a light emitting section, and at least a part (or the entire area) of the outer surface of the light emitting section may be brought into contact with the inner surface of the decorative member 302.

In such a case, a covering member made of resin, or a metallic back cover, for covering at least a part of the panel body 20 from its back side, may be attached to the inside (back surface side) of the building material.

In the building material in which the panel body 20 is directly fixed to the inner surface of the decorative member 302 as described above, a power supply member is connected to at least one of a plurality of panel bodies 20, and different panel bodies 20 may be electrically connected to each other by a conductive member or the like, as needed

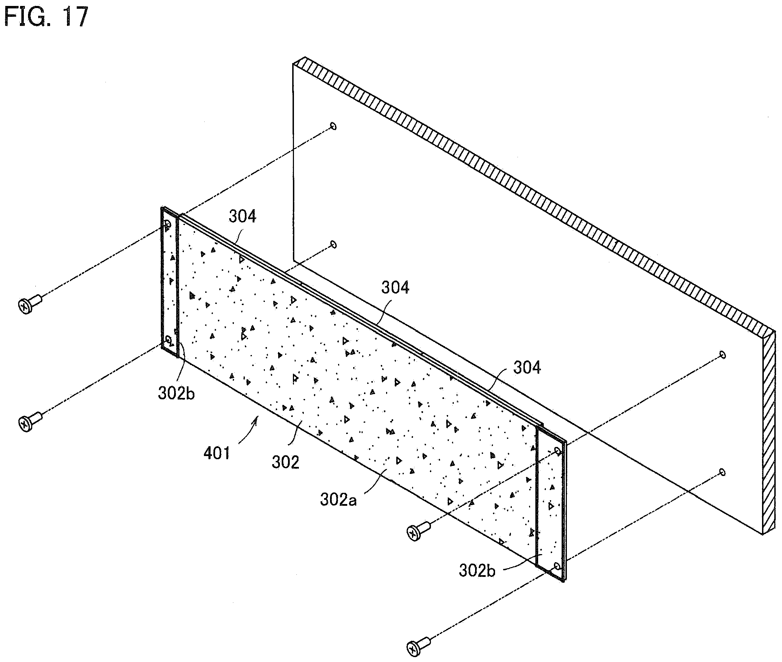

In addition, instead of a structure in which a building material is fixed to a wall surface with a building material mounting fixture (not illustrated), at least one of length in the vertical direction and length in the lateral direction of the decorative member 302 is increased to form a mounting hole in the decorative member 302 such that a fastening element may be inserted through the mounting hole to be fixed to the wall surface (refer to Fig. 17).

At this time, when the decorative member 302 is expanded in a spreading direction of each of its outer and inner surfaces, a part of the decorative member 302 serves as a panel non-overlapping section 302b that does not overlap with the planar light emitting device 304 (or the panel body 20) when viewed from the front.

Specifically, a part of the decorative member 302 serves as a panel overlapping section 302a that overlaps with the planar light emitting device 304 (or the panel body 20) when viewed from the front, and the other portion of the decorative member 302 serves as a panel non-overlapping section 302b. That is, in the decorative member 302, the planar light emitting device 304 (or the panel body 20) is positioned inside (backward) the panel overlapping section 302a, and the planar light emitting device 304 (or the panel body 20) is not positioned inside (backward) the panel non-overlapping section 302b.

When a mounting hole is formed in the panel non-overlapping section 302b and a fastening element is inserted through the formed mounting hole, a building material 401 (light-emitting-device-integrated building material) can be fixed to a wall surface.

The embodiment described above uses the decorative member 2 (the decorative member 202, or the decorative member 302) that is as a whole white and exhibits a pattern in which white spots darker than its periphery are irregularly scattered, and that has a structure in which the granular sections 11 are scattered inside. However, a decorative member available in the present invention is not limited to this.

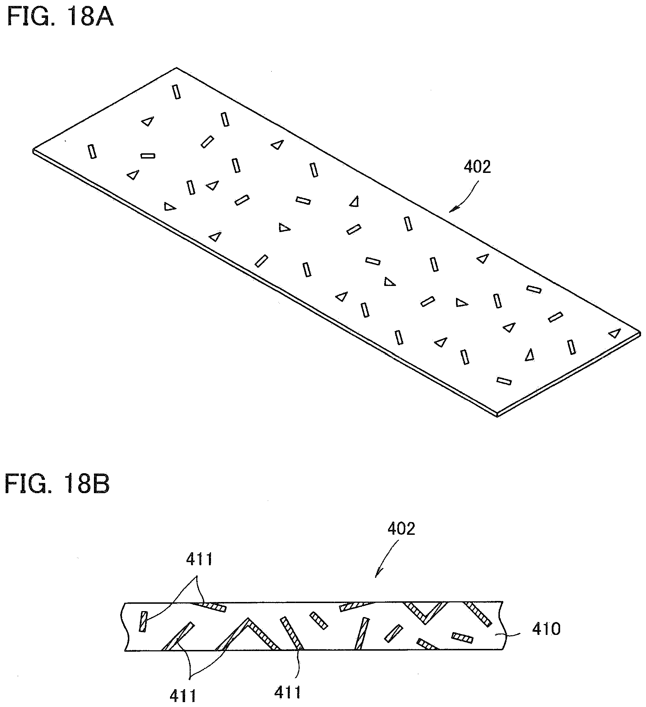

For example, a decorative member 402 as illustrated in Fig. 18 may be used.

The decorative member 402 is generally a light blue, more specifically, a semitransparent blue.

As illustrated in Fig. 18, the decorative member 402 includes a first colored layer 410 and a second colored layer 411 (second portion) each of which is translucent, the second colored layer 411 being scattered inside the first colored layer 410.

For convenience of drawing, in Fig. 18, only a part of the second colored layer 411 is denoted by a reference numeral, and the reference numerals to others are omitted.

The first colored layer 410 has a refractive index different from that of the second colored layer 411, and the second colored layer 411 has a refractive index of 110% or more and 140% or less of the refractive index of the first colored layer 410. That is, each of the granular sections 11 has a refractive index of about 125%.

That is, the decorative member 402 has a structure having two layers each having a different refractive index. In other words, the decorative member 402 is provided in its inside with a portion (the second colored layer 411) having a different refractive index from that of the other portion (the first colored layer 410). As illustrated in Fig. 18B, at least one of the second colored layers 411 has a structure including an oblique portion that extends in an oblique direction.

The term, "oblique direction" is an oblique direction in a section of the decorative member 402 taken along a plane orthogonal to its outer surface and inner surface, similar to the description above.

That is, at least a part of the second colored layer 411 includes a planar portion extending not only in a direction different from a direction orthogonal to the outer surface and the inner surface of the decorative member 402, but also in a direction crossing the outer surface and the inner surface of the decorative member 402.

It is preferable that the decorative member 402 also has a thickness similar to that of the decorative member 2 described above.

In each of the embodiments above described, while there is described an example of forming a wall surface of a structure with the building material 1, a ceiling surface and a floor surface of a structure may be formed by the building material 1.

In this case, the above longitudinal direction (member-thickness direction) is a vertical direction, and the vertical direction and the lateral direction are different two respective directions orthogonal to each other in a horizontal direction.

In the above embodiment, while an example in which the building material 1 is used as an interior material is described, the building material 1 may be used as an exterior material. That is, the building material 1 may be used in a state where the outer surface of the decorative member 2 faces the outdoor space.

In the above decorative member 2 (or decorative member 402), while there is described an example in which the granular section 11 (or the second colored layer 411) that has a refractive index different from that of its periphery, and that is colored different from its periphery, is positioned inside the decorative member 2, the present invention is not limited to this.

For example, the granular section and the second colored layer each may have the same refractive index as that of its periphery and may be colored different from its periphery. However, from a viewpoint of efficiently scattered light, it is preferable that the granular section and the second colored layer each have a different refractive index from that of its periphery.

The granular section and the second colored layer each may have a different refractive index from that of its periphery and may be colored the same color as its periphery.

EXAMPLE

Hereinafter, examples of the present invention and a comparative example will be described.
As examples and a comparative example, a prototype model using a panel body and a decorative member was prepared, and a relationship between luminance in each section of the prototype model and a shadow formed on an outer surface of the decorative member was verified.

(Example 1)

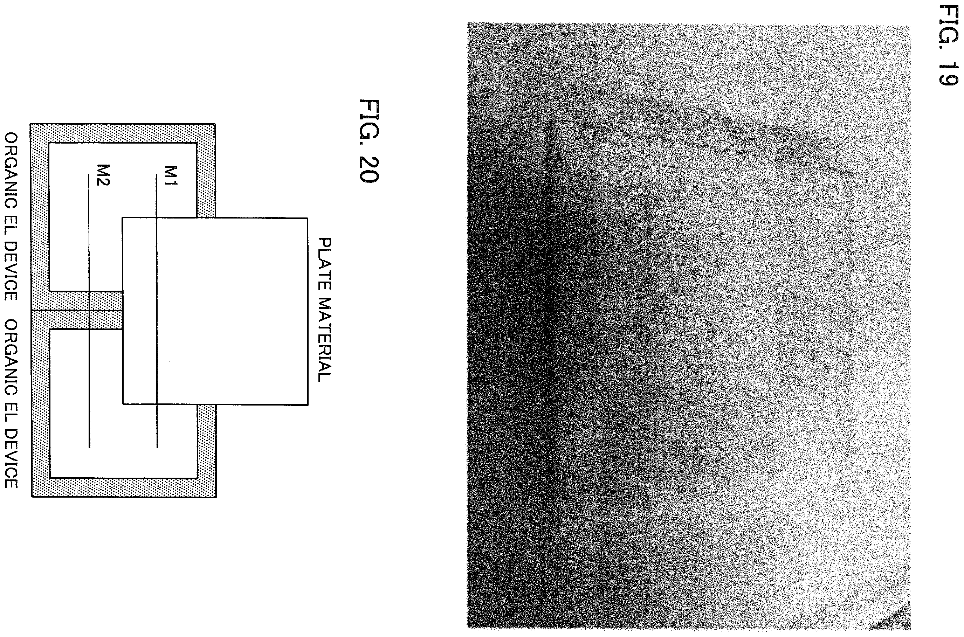

First, an organic EL device corresponding to the above panel body 20 and a plate material corresponding to the decorative member 2 (refer to Fig. 19) described above were prepared.
The organic EL device had a color temperature of 4000K.
The plate material was made of a metal oxide (mainly silica) as a main raw material. In addition, the plate material had a thickness of 8 mm, a square shape in plan view, and a side length of 100 mm in plan view.
Then, as illustrated in Fig. 20, the two organic EL devices were disposed in parallel, and the plate material was disposed such that a part of each of the two organic EL devices was covered therewith.
At that time, an end surface of the organic EL device was covered with a covering member instead of the frame member. That is, the end surface, a part of the main surface extending continuously to the end surface (a portion corresponding to the above peripheral region 20b), and a part of the back surface were covered with the covering member. Aluminum foil was used for the covering member.
The two organic EL devices were disposed such that their light emitting surfaces faced the same direction, and that an end of one of the organic EL devices and an end of the other were brought into contact with each other.
The plate material was disposed such that a part of a portion corresponding to the above inter-panel non-light emitting region 160, a part of a light emitting surface of the organic EL device adjacent to the part thereof, and a part of a light emitting surface of the other organic EL device, were covered with the plate material.
That is, the plate material in a quadrangular shape in plan view was disposed such that its two sides extended in the same direction as a parallel direction of the two organic EL devices. At that time, the plate material was disposed such that one of the two sides overlapped with a region where a boundary portion in which edges of the two organic EL devices were in contact with each other and its periphery, a light emitting surface of one of the organic EL devices, and a light emitting surface of the other of the organic EL devices extended continuously.
In other words, when the prototype model formed was viewed from a light emitting surface side of the organic EL device, a part of a portion corresponding to the inter-panel non-light emitting region 160 was covered with the plate material and the other portion was exposed in a visible state.
When the two organic EL devices were caused to emit light at a rated current, a luminance distribution was measured with a two-dimensional luminance meter, and then luminance on a straight line M1 and luminance on a straight line M2 in Fig. 20 were analyzed by line analysis. That is, luminance at a plurality of points on a front surface (outer side) of each portion overlapping with a predetermined straight line (the straight line M1 or the straight line M2) in front view was measured.
The expression, "on the straight line M1" means on each of surfaces described in the following (a1) to (a5).

(a1) A light emitting surface of one of the organic EL devices.
(a2) An outer surface of the plate material at a portion overlapping with the light emitting surface of the one of the organic EL devices.
(a3) An outer surface of the plate material at a portion overlapping with a boundary portion where edges of the two organic EL devices are in contact with each other and its periphery.
(a4) An outer surface of the plate material at a portion overlapping with a light emitting surface of the other of the organic EL devices.
(a5) The light emitting surface of the other of the organic EL devices.

The expression, "on the straight line M2" means on each of surfaces described in the following (b1) to (b3).

(b1) A light emitting surface of one of the organic EL devices.
(b2) An outer surface of a boundary portion where edges of the two organic EL devices are in contact with each other and its periphery.
(b3) The light emitting surface of the other of the organic EL devices.

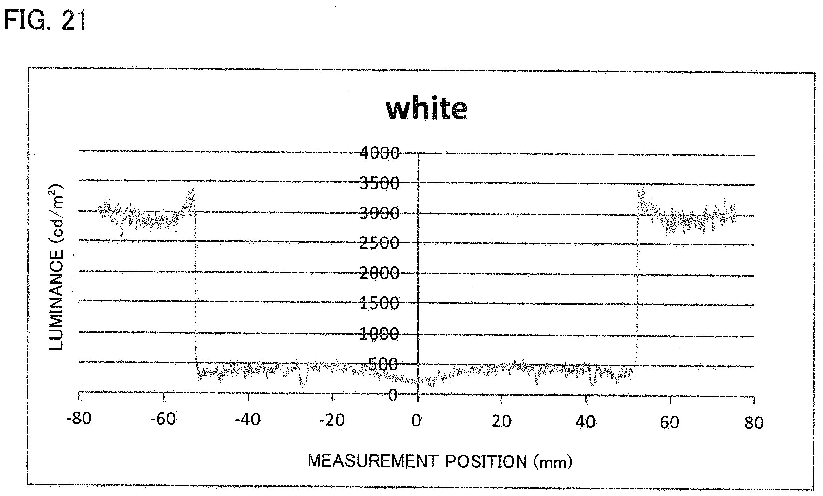

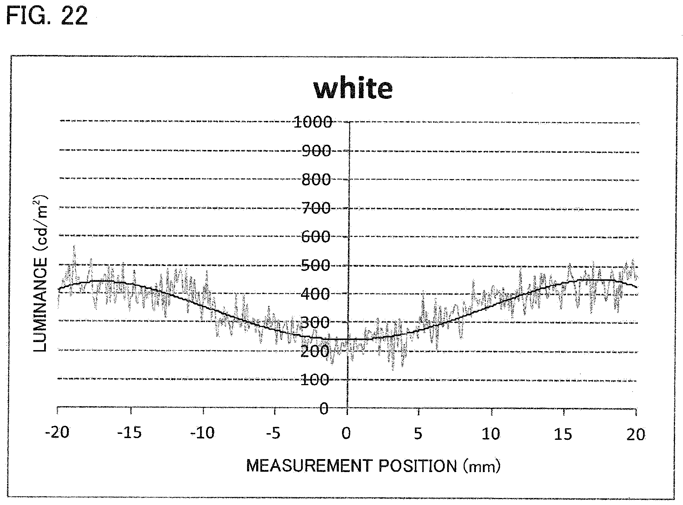

As a result of line analysis of the luminance on the straight line M1, results as in the graphs shown in Figs. 21 and 22 were obtained.

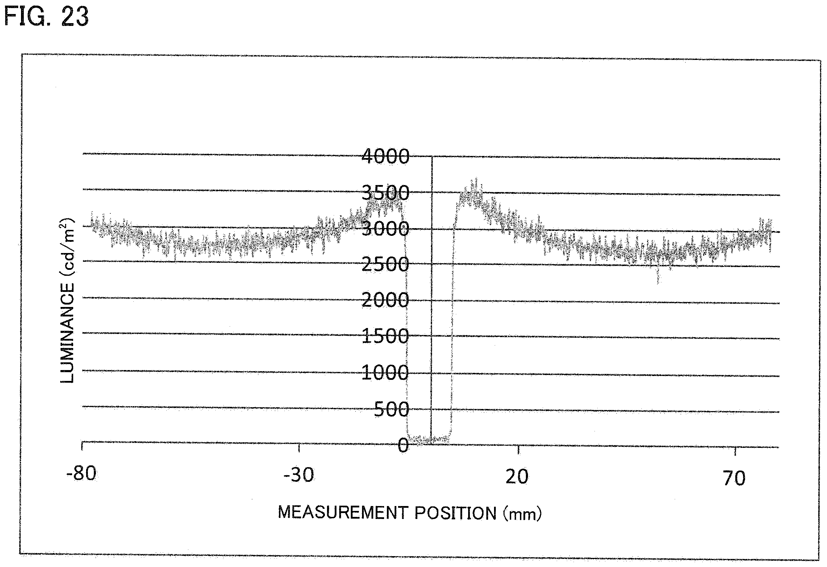

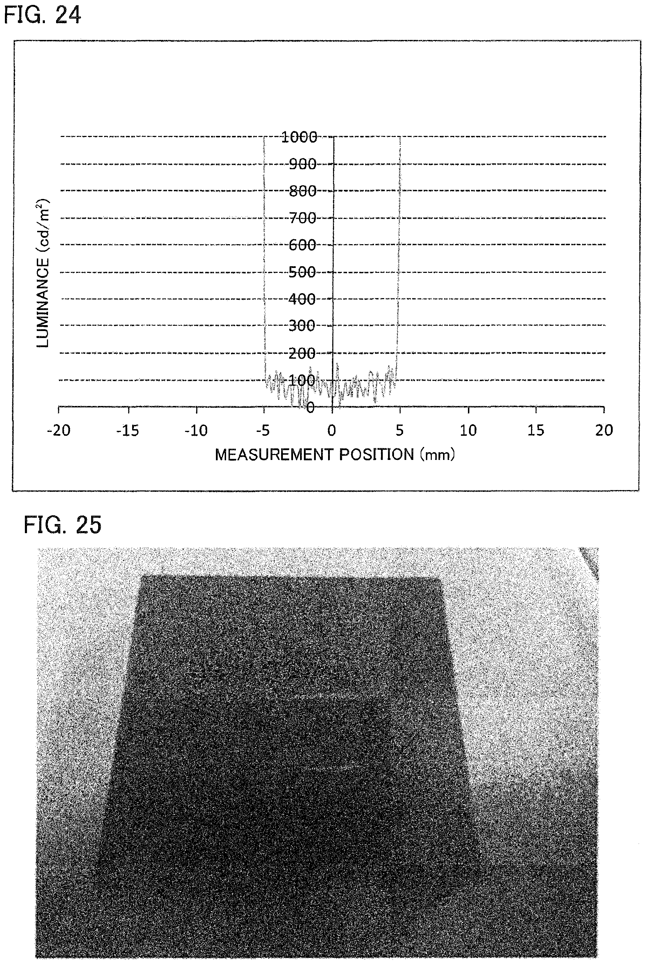

In addition, as a result of line analysis of the luminance on the straight line M2, results as in the graphs shown in Figs. 23 and 24 were obtained.

The expression, "MEASUREMENT POSITION (mm)" in the graph indicates that the boundary portion between the two organic EL devices is indicated as 0, a direction away from the boundary portion toward the one of the organic EL devices along a parallel direction of the organic EL devices is defined as a positive direction, and a direction away from the other of the organic EL devices along the parallel direction of the organic EL devices is defined as a negative direction. The unit is mm (millimeter). The same applies to other examples and comparative examples.

From the graphs shown in Figs. 23 and 24, the average value (A1) of luminance on an outer surface of a portion covering the boundary portion where the edges of the two organic EL devices were in contact with each other and its periphery was 53 cd/square meter.

From the graphs shown in Figs. 21 and 22, the average value (A2) of luminance on an outer surface of the plate material at a portion covering a boundary portion where the edges of the two organic EL devices were in contact with each other and its periphery was 240 cd/square meter.

Thus, the value of X1 in the following expression (A) was 352.8.

$$X1 = (A2/A1) * 100 - 100 \ ... \ (A)$$

From the graphs shown in Figs. 23 and 24, the average value (A3) of luminance in the light emitting section of each of the two organic EL devices was 2886 cd/square meter.

Thus, the value of X2 in the following expression (B) was 6.47.

$$X2 = ((A2 - A1)/A3) * 100 \ ... \ (B)$$

In the prototype model of Example 1, no visible shadow was formed on the outer surface of the portion of the plate material covering the light emitting surface of each of the organic EL devices, and on the outer surface of the portion of the plate material covering the boundary portion and its periphery of the two organic EL devices.

(Example 2)

A prototype model having the same structure as that in Example 1 was formed except that the plate material was different, and a relationship between luminance in each portion of the prototype model and a shadow formed on the outer surface of the decorative member was verified.

In Example 2, a plate material corresponding to the decorative member 402 (refer to Fig. 25) was used. That is, the plate material was made of a metal oxide (mainly silica) as a main raw material, and was different in color and layer structure from those of Example 1. The plate material was identical to the plate material used in Example 1 in thickness, shape in plan view, and length of each side.

Then, similar to Example 1, the luminance on the straight line M1 and the luminance on the straight line M2 were analyzed by line analysis.

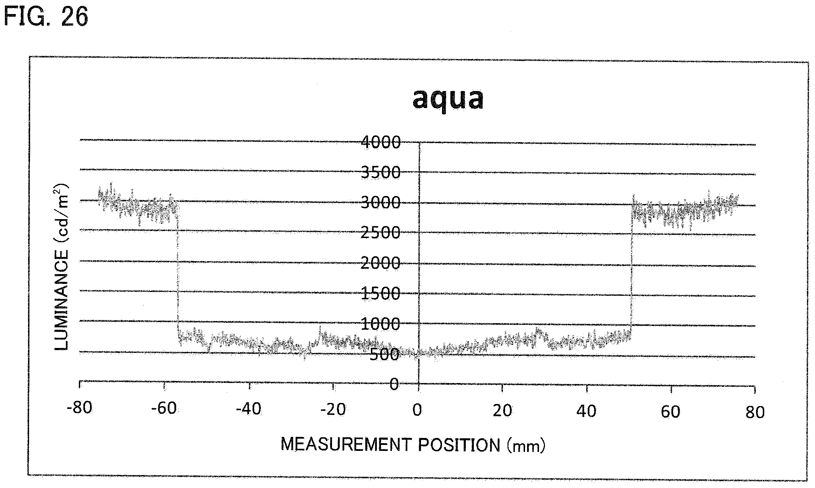

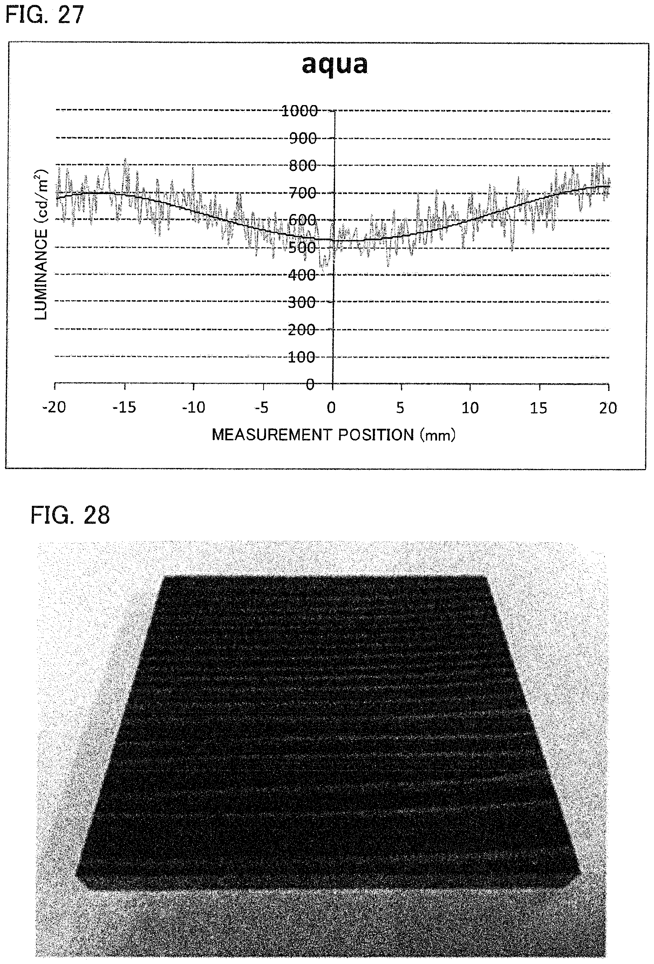

As a result of line analysis of the luminance on the straight line M1, results as in the graphs shown in Figs. 26 and 27 were obtained.

In addition, as a result of line analysis of the luminance on the straight line M2, similar results to the example 1 were obtained as in the graphs shown in Figs. 23 and 24.

Similar to Example 1, the average value (A1) of luminance on the outer surface of the portion covering the boundary portion where the edges of the two organic EL devices were in contact with each other and its periphery was 53 cd/square meter.

From the graphs shown in Figs. 26 and 27, the average value (A2) of the luminance on an outer surface of the plate material at a portion covering a boundary portion where the edges of the two organic EL devices were in contact with each other and its periphery was 528 cd/square meter.

Thus, the value of X1 in the following expression (A) was 896.

$$X1 = (A2/A1) * 100 - 100 \ ... \ (A)$$

Similar to Example 1, from the graphs shown in Figs. 23 and 24, the average value (A3) of the luminance in the light emitting section of each of the two organic EL devices was 2886 cd/square meter.

Thus, the value of X2 in the following expression (B) was 16.458.

$$X2 = ((A2 - A1)/A3) * 100 \ldots (B)$$

In the prototype model of Example 2, no visible shadow was formed on the outer surface of the portion covering the light emitting surface of each of the organic EL devices, and on the outer surface of the portion covering the boundary portion and its periphery of the two organic EL devices.

(Comparative Example)

A prototype model having the same structure as that in each of Examples 1 and 2 was formed except that the plate material was different, and a relationship between luminance in each portion of the prototype model and a shadow formed on the outer surface of the decorative member was verified.

In the comparative example, the plate material illustrated in Fig. 28 was used. That is, the plate material was formed by laminating a pattern forming layer on an outer surface of a transparent resin board. The pattern forming layer was formed of a wood-plastic composite material that is obtained by kneading wood flour and a thermoplastic resin.

In addition, the pattern forming layer was configured to form a wood grain pattern.

Then, similar to Examples 1 and 2, the luminance on the straight line M1 and the luminance on the straight line M2 were analyzed by line analysis.

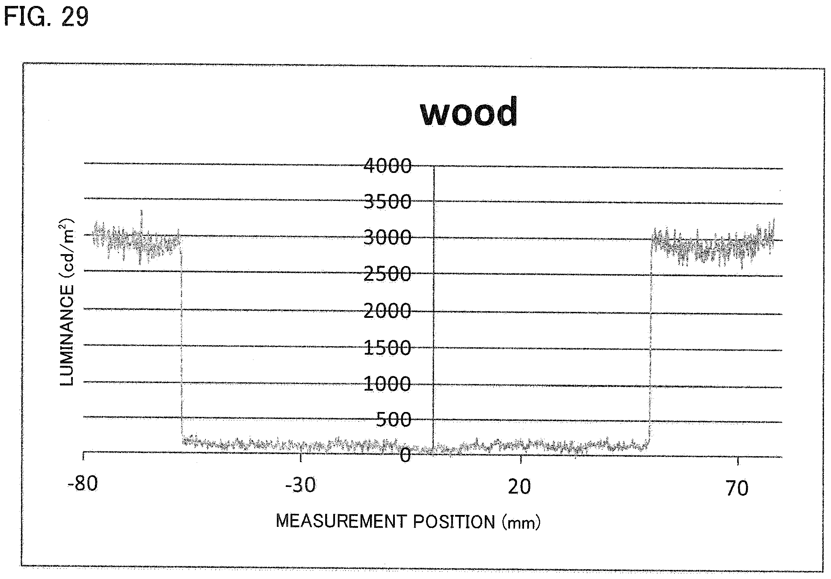

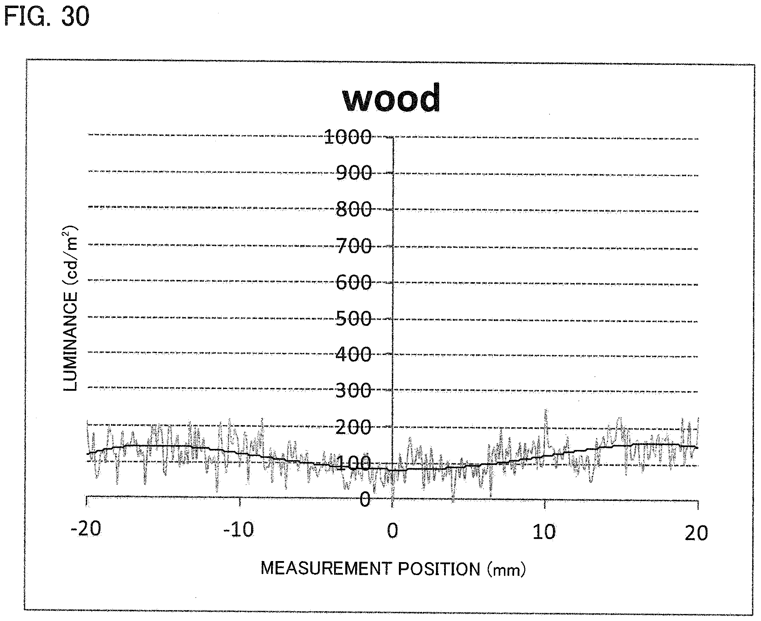

As a result of line analysis of the luminance on the straight line M1, results in the graphs shown in Figs. 29 and 30 were obtained.

In addition, as a result of line analysis of the luminance on the straight line M2, results as in the graphs shown in Figs. 23 and 24 were obtained, similar to Examples 1 and 2.

Similar to Examples 1 and 2, the average value (A1) of luminance on the outer surface of the portion covering the boundary portion where the edges of the two organic EL devices were in contact with each other and its periphery was 53 cd/square meter.

From the graphs shown in Figs. 29 and 30, the average value (A2) of the luminance on an outer surface of the plate material at a portion covering a boundary portion where the edges of the two organic EL devices were in contact with each other and its periphery was 82 cd/square meter.

Thus, the value of X1 in the following expression (A) was 54.7.

$$X1 = (A2/A1) * 100 - 100 \ldots (A)$$

Similar to Example 1, from the graphs shown in Figs. 23 and 24, the average value (A3) of the luminance in the light emitting section of each of the two organic EL devices was 2886 cd/square meter.

Thus, the value of X2 in the following expression (B) was 1.00485.

$$X2 = ((A2 - A1)/A3) * 100 \ldots (B)$$

In the prototype model of the comparative example, no visible shadow was formed on the outer surface of the portion of the plate material covering the light emitting surface of each of the organic EL devices. However, a shadow extending linearly was visually observed on the outer surface of the portion of the plate material covering the boundary portion of the two organic EL devices and their periphery. That is, the shadow extending in the direction orthogonal to the parallel direction of the two organic EL devices (the vertical direction in Fig. 20) was formed on the outer surface of the plate material.

EXPLANATION OF REFERENCE SIGNS

1, 81, 201, 301, 401: building material (light-emitting-device-integrated building material)
2, 72, 82, 202, 302, 402: decorative member

3, 203: inner light emitting section
4, 104, 304: planar light emitting device (surface emitting panel)
11: granular section (second portion)
20, 120: panel body
21, 121: frame member
50, 150: light emitting section
56: inter-panel space
60, 160: inter-panel non-light emitting region
207: mounting fixture (panel mounting member)
410: first colored layer
411: second colored layer (second portion)
$\alpha$1: projection plane overlapping region

**Claims**

1. A light-emitting-device-integrated building material (1, 81, 201, 301, 401) that constitutes at least part of an external surface of a structure, comprising:

a decorative member (2, 72, 82, 202, 302, 402), part of its outer surface constituting the external surface; and two or more of surface emitting panels (4, 104, 304) disposed in parallel such that each of their light emitting surfaces faces outward, the two or more of surface emitting panels constituting an inner light emitting section (3, 203),
wherein the two or more of surface emitting panels comprises a first surface emitting panel and a second surface emitting panel, the first surface emitting panel and the second surface emitting panel being disposed adjacent to each other in a parallel direction, the first surface emitting panel and the second surface emitting panel being disposed in contact with each other or at an interval,
wherein an inter-panel non-light emitting region (60, 160) is constituted between a light emitting surface of the first surface emitting panel and a light emitting surface of the second surface emitting panel, the inter-panel non-light emitting region including at least a boundary portion between the first surface emitting panel and the second surface emitting panel, or at least the interval,
wherein the decorative member is disposed outside the inner light emitting section and across the light emitting surface of the first surface emitting panel, the inter-panel non-light emitting region, and the light emitting surface of the second surface emitting panel, and
an outer surface of the decorative member including a projection plane overlapping region ($\alpha$1) disposed outside the inter-panel non-light emitting region,
**characterised in that**: the decorative member and the inner light emitting section satisfy a following condition (1):

(1) when an average value of luminance per unit area of the inter-panel non-light emitting region in a front view is indicated as A1, and an average value of luminance per unit area of the projection plane overlapping region is indicated as A2, a value of X1 in the following expression (A) is 55 or more and 3000 or less,

$$X1 = (A2/A1) * 100 - 100 \,...\, (A),$$

wherein a plurality of second portions (11) each having a refractive index different from that of an adjacent portion are provided inside the decorative member, and

wherein at least one of the second portions has a planar portion extending in a direction that is different from a direction orthogonal to the outer surface of the decorative member, and that intersects with the outer surface of the decorative member.

2. The light-emitting-device-integrated building material (1, 81, 201, 301, 401) according to claim 1, wherein the two light emitting surfaces of the first surface emitting panel (4, 104, 304) and the second surface emitting panel (4, 104, 304) are defined each as a reference light emitting surface, the two light emitting surfaces being adjacent to the inter-panel non-light emitting region (60, 160), and
wherein the decorative member (2, 72, 82, 202, 302, 402) and the inner light emitting section satisfy a relation of the following condition (2):

(2) when an average value of luminance per unit area of the reference light emitting surface is indicated as A3, a value of X2 in the following expression (B) is 1.5 or more and 100 or less,

$$X2 = ((A2 - A1)/A3) * 100 \ ... \ (B).$$

3. The light-emitting-device-integrated building material (1, 81, 201, 301, 401) according to any one of claims 1 to 2, wherein the surface emitting panel (4, 104, 304) comprises a panel body (20, 120) and a frame member (21, 121), wherein at least part of the frame member is disposed adjacent to the boundary portion or the interval, and wherein at least part of an outer surface of the frame member is a reflecting surface that reflects light, the part of the outer surface being disposed adjacent to the boundary portion or the interval.

4. The light-emitting-device-integrated building material (1, 81, 201, 301, 401) according to any one of claims 1 to 3, wherein a distance between the light emitting surface of the surface emitting panel and an inner surface of the decorative member is 2 mm or more and 10 mm or less.

5. The light-emitting-device-integrated building material (1, 81, 201, 301, 401) according to any one of claims 1 to 4, wherein the decorative member (2, 72, 82, 202, 302, 402) has a thickness direction orthogonal to the outer surface of the decorative member, a thickness of the decorative member being 3 mm or more and 50 mm or less.

6. The light-emitting-device-integrated building material (1, 81, 201, 301, 401) according to any one of claims 1 to 5, wherein the decorative member (2, 72, 82, 202, 302, 402) is disposed with its inner surface in contact with the light emitting surfaces of the first and the second surface emitting panels (4, 104, 304) or with its inner surface away outward from the light emitting surfaces; and wherein there is not another member between the inner surface of the decorative member and the light emitting surface of the first surface emitting panel, between the inner surface of the decorative member and the inter-panel non-light emitting region (60, 160), and between the inner surface of the decorative member and the light emitting surface of the second surface emitting panel.

7. The light-emitting-device-integrated building material (1, 81, 201, 301, 401) according to any one of claims 1 to 6, wherein the inner light emitting section (3, 203) comprises three or more of the surface emitting panels (4, 104, 304) in parallel, the decorative (2, 72, 82, 202, 302, 402) member being disposed outside a portion across the three or more of the surface emitting panels so as to overlap with at least a part of each of the surface emitting panels in an inside-outside direction, wherein the surface emitting panels provided in the inner light emitting section are electrically connected to each other in series, and wherein each of the surface emitting panels has substantially identical average value of luminance per unit area on its light emitting surface.

8. The light-emitting-device-integrated building material (1, 81, 201, 301, 401) according to any one of claims 1 to 7, wherein the surface emitting panel (4, 104, 304) is an organic EL panel that emits scattered light.

9. The light-emitting-device-integrated building material (1, 81, 201, 301, 401) according to any one of claims 1 to 8, wherein the second portions (11) are each a translucent granular section, wherein the decorative member (2, 72, 82, 202, 302, 402) includes a translucent colored layer (410) having a plurality of the granular sections (411) scattered inside the colored layer, the colored layer and the granular sections with different refractive indices being disposed adjacent to each other inside the decorative member, and wherein the plurality of the granular sections includes a first of the granular section and a second of the granular section each having at least a different outline or a grain size.

10. The light-emitting-device-integrated building material (1, 81, 201, 301, 401) according to any one of claims 1 to 8, wherein the second portions (11) are a second translucent colored layer (411), and wherein the decorative member includes a first translucent colored layer (410) having the second colored layer therein, the first and the second colored layers with a different refractive index being disposed adjacent to each other.

11. The light-emitting-device-integrated building material (1, 81, 201, 301, 401) according to any one of claims 1 to 10,

wherein the light-emitting-device-integrated building material comprises a panel mounting member (207) fixing a plurality of the surface emitting panels (4, 104, 304) to constitute the inner light emitting section (3, 203),

wherein the panel mounting member comprises recessed sections that allows the plurality of the surface emitting panels therein, and

wherein each of the plurality of the surface emitting panels is fitted into the different recessed section to be disposed in parallel.

**Patentansprüche**

1. Baustoff (1, 81, 201, 301, 401) mit integrierter lichtemittierender Vorrichtung, der mindestens einen Teil einer externen Oberfläche einer Struktur bildet, umfassend:

ein dekoratives Element (2, 72, 82, 202, 302, 402), wobei ein Teil seiner äußeren Oberfläche die externe Oberfläche bildet; und

zwei oder mehrere emittierende Oberflächenpaneele (4, 104, 304), die parallel angeordnet sind, so dass jede ihrer lichtemittierenden Oberflächen nach außen weist, wobei die zwei oder mehreren emittierenden Oberflächenpaneele eine innere Licht emittierende Sektion (3, 203) bilden,

wobei die zwei oder mehreren emittierenden Oberflächenpaneele ein erstes emittierendes Oberflächenpaneel und ein zweites emittierendes Oberflächenpaneel umfassen, wobei das erste emittierende Oberflächenpaneel und das zweite emittierende Oberflächenpaneel in einer parallelen Richtung nebeneinander angeordnet sind, wobei das erste emittierende Oberflächenpaneel und das zweite emittierende Oberflächenpaneel in Kontakt miteinander oder in einem Intervall angeordnet sind,

wobei ein nicht lichtemittierender Bereich (60, 160) zwischen Paneelen zwischen einer lichtemittierenden Oberfläche des ersten emittierenden Oberflächenpaneels und einer lichtemittierenden Oberfläche des zweiten emittierenden Oberflächenpaneels gebildet ist, wobei der nicht lichtemittierende Bereich zwischen Paneelen mindestens einen Grenzabschnitt zwischen dem ersten emittierenden Oberflächenpaneel und dem zweiten emittierende Oberflächenpaneel oder mindestens das Intervall einschließt,

wobei das dekorative Element außerhalb der inneren lichtemittierenden Sektion und über die lichtemittierende Oberfläche des ersten emittierenden Oberflächenpaneels, den nicht lichtemittierenden Bereich zwischen Paneelen und die lichtemittierende Oberfläche des zweiten emittierenden Oberflächenpaneels angeordnet ist, und eine äußere Oberfläche des dekorativen Elements einen Überlappungsbereich ($\alpha$1) der Projektionsebene einschließt, der außerhalb des nicht lichtemittierenden Bereichs zwischen den Paneelen angeordnet ist,

**dadurch gekennzeichnet, dass**: das dekorative Element und die innere lichtemittierende Sektion die folgende Bedingung (1) erfüllen:

(1) wenn ein durchschnittlicher Leuchtdichtewert pro Flächeneinheit des nicht lichtemittierenden Bereichs zwischen Paneelen in einer Vorderansicht als A1 angegeben ist und ein durchschnittlicher Leuchtdichtewert pro Flächeneinheit des Überlappungsbereichs der Projektionsebene als A2 angegeben ist, ein Wert von X1 im folgenden Ausdruck (A) 55 oder mehr und 3000 oder weniger beträgt,

folgenden Ausdruck (A) 55 oder mehr und 3000 oder weniger beträgt, $X1 = (A2/A1) * 100-100 ... (A)$,

wobei eine Vielzahl von zweiten Abschnitten (11), die jeweils einen Brechungsindex aufweisen, der sich von dem eines benachbarten Abschnitts unterscheidet, innerhalb des dekorativen Elements bereitgestellt sind, und wobei mindestens einer der zweiten Abschnitte einen ebenen Abschnitt aufweist, der sich in einer Richtung erstreckt, die sich von einer Richtung unterscheidet, die orthogonal zur äußeren Oberfläche des dekorativen Elements ist und die sich mit der äußeren Oberfläche des dekorativen Elements schneidet.

2. Baustoff (1, 81, 201, 301, 401) mit integrierter lichtemittierender Vorrichtung nach Anspruch 1, wobei die zwei lichtemittierenden Oberflächen des ersten emittierenden Oberflächenpaneels (4, 104, 304) und des zweiten emittierenden Oberflächenpaneels (4, 104, 304) jeweils als lichtemittierende Referenzoberfläche definiert sind, wobei die beiden lichtemittierenden Oberflächen benachbart zu dem nicht lichtemittierenden Bereich (60, 160) zwischen Paneelen liegen, und

wobei das dekorative Element (2, 72, 82, 202, 302, 402) und die innere lichtemittierende Sektion eine Beziehung der folgenden Bedingung (2) erfüllen:

(2) wenn ein durchschnittlicher Leuchtdichtewert pro Flächeneinheit der lichtemittierenden Referenzoberfläche als A3 angegeben ist, ein Wert von X2 im folgenden Ausdruck (B) 1,5 oder mehr und 100 oder weniger beträgt,

folgenden Ausdruck (B) 1,5 oder mehr und 100 oder weniger beträgt, $X2 = ((A2 - A1)/A3) * 100 ... (B)$.

3. Baustoff (1, 81, 201, 301, 401) mit integrierter lichtemittierender Vorrichtung nach einem der Ansprüche 1 bis 2, wobei das emittierende Oberflächenpaneel (4, 104, 304) einen Paneelkörper (20, 120) und ein Rahmenelement (21, 121) umfasst,
wobei mindestens ein Teil des Rahmenelements benachbart zu dem Grenzabschnitt oder dem Intervall angeordnet ist und
wobei mindestens ein Teil einer äußeren Oberfläche des Rahmenelements eine reflektierende Oberfläche ist, die Licht reflektiert, wobei der Teil der äußeren Oberfläche benachbart zum Grenzabschnitt oder dem Intervall angeordnet ist.

4. Baustoff (1, 81, 201, 301, 401) mit integrierter lichtemittierender Vorrichtung nach einem der Ansprüche 1 bis 3, wobei ein Abstand zwischen der lichtemittierenden Oberfläche des emittierenden Oberflächenpaneels und einer inneren Oberfläche des dekorativen Elements 2 mm oder mehr und 10 mm oder weniger ist.

5. Baustoff (1, 81, 201, 301, 401) mit integrierter lichtemittierender Vorrichtung nach einem der Ansprüche 1 bis 4, wobei das dekorative Element (2, 72, 82, 202, 302, 402) eine Dickenrichtung aufweist, die orthogonal zur äußeren Oberfläche des dekorativen Elements liegt, wobei eine Dicke des dekorativen Elements 3 mm oder mehr und 50 mm oder weniger beträgt.

6. Baustoff (1, 81, 201, 301, 401) mit integrierter lichtemittierender Vorrichtung nach einem der Ansprüche 1 bis 5, wobei das dekorative Element (2, 72, 82, 202, 302, 402) mit seiner inneren Oberfläche in Kontakt mit den lichtemittierenden Oberflächen des ersten und des zweiten emittierenden Oberflächenpaneels (4, 104, 304) oder mit seiner inneren Oberfläche weg nach außen von den lichtemittierenden Oberflächen angeordnet ist; und
wobei kein weiteres Element zwischen der inneren Oberfläche des dekorativen Elements und der lichtemittierenden Oberfläche des ersten emittierenden Oberflächenpaneels, zwischen der inneren Oberfläche des dekorativen Elements und dem nicht lichtemittierenden Bereich zwischen Paneelen (60, 160); und zwischen der inneren Oberfläche des dekorativen Elements und der lichtemittierenden Oberfläche des zweiten emittierenden Oberflächenpaneels vorhanden ist.

7. Baustoff (1, 81, 201, 301, 401) mit integrierter lichtemittierender Vorrichtung nach einem der Ansprüche 1 bis 6, wobei die innere lichtemittierende Sektion (3, 203) drei oder mehr emittierende Oberflächenpaneele (4, 104, 304) parallel umfasst, wobei das dekorative Element (2, 72, 82, 202, 302, 402) außerhalb eines Abschnitts über die drei oder mehr der emittierenden Oberflächenpaneele angeordnet ist, um sich mit mindestens einem Teil jedes der emittierenden Oberflächenpaneele in einer Innen-Außen-Richtung zu überlappen,
wobei die in der inneren lichtemittierenden Sektion bereitgestellten emittierenden Oberflächenpaneele in Reihe elektrisch miteinander verbunden sind und
wobei jedes der emittierenden Oberflächenpaneele einen im Wesentlichen identischen durchschnittlichen Leuchtdichtewert pro Flächeneinheit auf ihrer lichtemittierenden Oberfläche aufweist.

8. Baustoff (1, 81, 201, 301, 401) mit integrierter lichtemittierender Vorrichtung nach einem der Ansprüche 1 bis 7, wobei das emittierenden Oberflächenpaneel (4, 104, 304) ein organisches EL-Paneel ist, das gestreutes Licht emittiert.

9. Baustoff (1, 81, 201, 301, 401) mit integrierter lichtemittierender Vorrichtung nach einem der Ansprüche 1 bis 8, wobei die zweiten Abschnitte (11) jeweils eine durchscheinende körnige Sektion sind,
wobei das dekorative Element (2, 72, 82, 202, 302, 402) eine durchscheinende farbige Schicht (410) einschließt,
wobei eine Vielzahl der körnigen Sektionen (411) innerhalb der farbigen Schicht gestreut sind und die farbige Schicht und die körnigen Sektionen mit unterschiedlichen Brechungsindizes benachbart zueinander innerhalb des dekorativen Elements angeordnet sind, und
wobei die Vielzahl der körnigen Sektionen einen ersten der körnigen Sektion und einen zweiten der körnigen Sektion einschließt, die jeweils mindestens einen unterschiedlichen Umriss oder eine unterschiedliche Korngröße aufweisen.

**10.** Baustoff (1, 81, 201, 301, 401) mit integrierter lichtemittierender Vorrichtung nach einem der Ansprüche 1 bis 8, wobei die zweiten Abschnitte (11) eine zweite durchscheinende farbige Schicht (411) sind und wobei das dekorative Element eine erste durchscheinende farbige Schicht (410), die zweite farbige Schicht darin aufweisend einschließt, wobei die erste und die zweite farbige Schicht mit einem unterschiedlichen Brechungsindex benachbart zueinander angeordnet sind.

**11.** Baustoff (1, 81, 201, 301, 401) mit integrierter lichtemittierender Vorrichtung nach einem der Ansprüche 1 bis 10, wobei der Baustoff mit integrierter lichtemittierender Vorrichtung ein Paneelmontageelement (207) umfasst, das eine Vielzahl der emittierenden Oberflächenpaneele (4, 104, 304) fixiert, um die innere lichtemittierende Sektion (3, 203) zu bilden, wobei das Paneel-Montageelement vertiefte Sektionen umfasst, die die Vielzahl der emittierenden Oberflächenpaneele darin zulassen, und wobei jedes der Vielzahl der emittierenden Oberflächenpaneele in die verschiedene vertiefte Sektion eingepasst ist, um parallel angeordnet zu werden.

**Revendications**

**1.** Matériau de construction à dispositif électroluminescent intégré (1, 81, 201, 301, 401) qui constitue au moins une partie d'une surface externe d'une structure, comprenant :

un élément décoratif (2, 72, 82, 202, 302, 402), une partie de sa surface extérieure constituant la surface externe ; et
au moins deux panneaux à émission de surface (4, 104, 304) disposés en parallèle de telle sorte que chacune de leurs surfaces électroluminescentes soit tournée vers l'extérieur, les au moins deux panneaux à émission de surface constituant une section électroluminescente intérieure (3, 203),
dans lequel les au moins deux panneaux à émission de surface comprennent un premier panneau à émission de surface et un second panneau à émission de surface, le premier panneau à émission de surface et le second panneau à émission de surface ou plus étant disposés adjacents l'un à l'autre dans une direction parallèle, le premier panneau à émission de surface et le second panneau à émission de surface étant disposés en contact l'un avec l'autre ou à un intervalle,
dans lequel une région non électroluminescente inter-panneaux (60, 160) est constituée entre une surface électroluminescente du premier panneau à émission de surface et une surface électroluminescente du second panneau à émission de surface, la région non électroluminescente inter-panneaux incluant au moins une partie de limite entre le premier panneau à émission de surface et le second panneau à émission de surface, ou au moins l'intervalle,
dans lequel l'élément décoratif est disposé à l'extérieur de la section électroluminescente intérieure et à travers la surface électroluminescente du premier panneau à émission de surface, la région non électroluminescente inter-panneaux et la surface électroluminescente du second panneau à émission de surface, et
une surface extérieure de l'élément décoratif incluant une région de chevauchement de plan de projection ($\alpha$1) disposée à l'extérieur de la région non électroluminescente inter-panneaux,
**caractérisé en ce que** : l'élément décoratif et la section électroluminescente intérieure satisfont à une condition (1) suivante :

(1) lorsqu'une valeur moyenne de luminance par unité de surface de la région non électroluminescente inter-panneaux dans une vue avant est indiquée par A1, et une valeur moyenne de luminance par unité de surface de la région de chevauchement de plan de projection est indiquée par A2, une valeur de X1 dans l'expression (A) suivante est 55 ou plus et 3000 ou moins,

$$X1 = (A2/A1) * 100 - 100 ... (A),$$

dans lequel une pluralité de secondes parties (11) ayant chacune un indice de réfraction différent de celui d'une partie adjacente sont prévues à l'intérieur de l'élément décoratif, et
dans lequel au moins une des secondes parties a une partie plane s'étendant dans une direction qui est différente d'une direction orthogonale à la surface extérieure de l'élément décoratif, et qui recoupe la surface extérieure de l'élément décoratif.

**2.** Matériau de construction à dispositif électroluminescent intégré (1, 81, 201, 301, 401) selon la revendication 1, dans lequel les deux surfaces électroluminescentes du premier panneau à émission de surface (4, 104, 304) et du second panneau à émission de surface (4, 104, 304) sont définies chacune comme une surface électroluminescente de référence, les deux surfaces électroluminescentes étant adjacentes à la région non électroluminescente inter-panneaux (60, 160), et
dans lequel l'élément décoratif (2, 72, 82, 202, 302, 402) et la section électroluminescente intérieure satisfont une relation de la condition (2) suivante :
(2) lorsqu'une valeur moyenne de luminance par unité de surface de la surface électroluminescente de référence est indiquée par A3, une valeur de X2 dans l'expression (B) suivante est 1,5 ou plus et 100 ou moins,

$$X2 = ((A2 - A1)/A3) * 100 ... (B).$$

**3.** Matériau de construction à dispositif électroluminescent intégré (1, 81, 201, 301, 401) selon l'une quelconque des revendications 1 à 2,
dans lequel le panneau à émission de surface (4, 104, 304) comprend un corps de panneau (20, 120) et un élément de cadre (21, 121),
dans lequel au moins une partie de l'élément de cadre est disposée adjacente à la partie de limite ou à l'intervalle, et
dans lequel au moins une partie d'une surface extérieure de l'élément de cadre est une surface réfléchissante qui réfléchit la lumière, la partie de la surface extérieure étant disposée adjacente à la partie de limite ou à l'intervalle.

**4.** Matériau de construction à dispositif électroluminescent intégré (1, 81, 201, 301, 401) selon l'une quelconque des revendications 1 à 3, dans lequel une distance entre la surface électroluminescente du panneau à émission de surface et une surface intérieure de l'élément décoratif est de 2 mm ou plus et 10 mm ou moins.

**5.** Matériau de construction à dispositif électroluminescent intégré (1, 81, 201, 301, 401) selon l'une quelconque des revendications 1 à 4, dans lequel l'élément décoratif (2, 72, 82, 202, 302, 402) a une direction d'épaisseur orthogonale à la surface extérieure de l'élément décoratif, une épaisseur de l'élément décoratif étant de 3 mm ou plus et de 50 mm ou moins.

**6.** Matériau de construction à dispositif électroluminescent intégré (1, 81, 201, 301, 401) selon l'une quelconque des revendications 1 à 5,
dans lequel l'élément décoratif (2, 72, 82, 202, 302, 402) est disposé avec sa surface intérieure en contact avec les surfaces électroluminescentes des premier et second panneaux à émission de surface (4, 104, 304) ou avec sa surface intérieure à l'extérieur des surfaces électroluminescentes ; et
dans lequel il n'existe pas d'autre élément entre la surface intérieure de l'élément décoratif et la surface électroluminescente du premier panneau à émission de surface, entre la surface intérieure de l'élément décoratif et la région non électroluminescente inter-panneaux (60, 160), et entre la surface intérieure de l'élément décoratif et la surface électroluminescente du second panneau à émission de surface.

**7.** Matériau de construction à dispositif électroluminescent intégré (1, 81, 201, 301, 401) selon l'une quelconque des revendications 1 à 6,
dans lequel la section électroluminescente intérieure (3, 203) comprend au moins trois panneaux à émission de surface (4, 104, 304) en parallèle, l'élément décoratif (2, 72, 82, 202, 302, 402) étant disposé à l'extérieur d'une partie à travers les au moins trois panneaux à émission de surface de manière à chevaucher au moins une partie de chacun des panneaux à émission de surface dans une direction intérieur-extérieur,
dans lequel les panneaux à émission de surface prévus dans la section électroluminescente intérieure sont connectés électriquement les uns aux autres en série, et
dans lequel chacun des panneaux à émission de surface a une valeur moyenne de luminance par unité de surface sensiblement identique sur sa surface électroluminescente.

**8.** Matériau de construction à dispositif électroluminescent intégré (1, 81, 201, 301, 401) selon l'une quelconque des revendications 1 à 7, dans lequel le panneau à émission de surface (4, 104, 304) est un panneau EL organique qui émet une lumière dispersée.

**9.** Matériau de construction à dispositif électroluminescent intégré (1, 81, 201, 301, 401) selon l'une quelconque des revendications 1 à 8,

dans lequel les secondes parties (11) sont chacune une section granulaire translucide,

dans lequel l'élément décoratif (2, 72, 82, 202, 302, 402) inclut une couche colorée translucide (410) ayant une pluralité des sections granulaires (411) dispersées à l'intérieur de la couche colorée, la couche colorée et les sections granulaires avec différents indices de réfraction étant disposées adjacentes l'une à l'autre à l'intérieur de l'élément décoratif, et

dans lequel la pluralité des sections granulaires inclut une première de la section granulaire et une seconde de la section granulaire ayant chacune au moins un contour différent ou une taille de grain différente.

10. Matériau de construction à dispositif électroluminescent intégré (1, 81, 201, 301, 401) selon l'une quelconque des revendications 1 à 8,

dans lequel les secondes parties (11) sont une seconde couche colorée translucide (411), et

dans lequel l'élément décoratif inclut une première couche colorée translucide (410) contenant la seconde couche colorée en son sein, les première et seconde couches colorées avec un indice de réfraction différent étant disposées adjacentes l'une à l'autre.

11. Matériau de construction à dispositif électroluminescent intégré (1, 81, 201, 301, 401) selon l'une quelconque des revendications 1 à 10,

dans lequel le matériau de construction à dispositif électroluminescent intégré comprend un élément de montage de panneau (207) fixant une pluralité des panneaux à émission de surface (4, 104, 304) pour constituer la section électroluminescente intérieure (3, 203),

dans lequel l'élément de montage de panneau comprend des sections évidées qui acceptent la pluralité des panneaux à émission de surface en leur sein, et

dans lequel chacun de la pluralité des panneaux à émission de surface est ajusté dans la section évidée différente pour être disposé en parallèle.

FIG. 1

## FIG. 2A

## FIG. 2B

FIG. 3

FIG. 4A

2

FIG. 4B

11  11  2

10

FIG. 5

FIG. 6

EP 3 336 424 B1

FIG. 7

FIG. 8

## FIG. 9A

## FIG. 9B

FIG. 10A

FIG. 10B

FIG. 11A

82

82a

FIG. 11B

82

82a

3

4

82

81

4

3

FIG. 12

FIG. 13

## FIG. 14

201

121

104

203

207

104

121

104

121

202

## FIG. 15

203

142(121)    160    142(121)    160    142(121)    207

140(121)    141(121)         140(121)         141(121)    104

104                    141(121)         140(121)

150              150              150

143(121)         143(121)         143(121)

d5    104    d5

104

FIG. 16

FIG. 17

FIG. 18A

402

FIG. 18B

411

402

411    411

411

410

FIG. 19

FIG. 20

PLATE MATERIAL

M1

M2

ORGANIC EL DEVICE    ORGANIC EL DEVICE

FIG. 21

white

EP 3 336 424 B1

FIG. 22

FIG. 23

EP 3 336 424 B1

## FIG. 24

## FIG. 25

FIG. 26

aqua

## FIG. 27

## FIG. 28

FIG. 29

wood

LUMINANCE (cd/m²)

4000
3500
3000
2500
2000
1500
1000
500
0

-80    -30    0    20    70

MEASUREMENT POSITION (mm)

FIG. 30

**wood**

EP 3 336 424 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016021347 A

- WO 2015071454 A1